# EUROPEAN PATENT APPLICATION

(11) **EP 4 461 593 A1**
(43) Date of publication of application: **13.11.2024**
(21) Application number: 23746190.0
(22) Date of filing: 18.01.2023
(51) Int. Cl.: B60L 53/31

(54) **HEAT DISSIPATION SYSTEM, POWER SUPPLY SYSTEM, AND CHARGING PILE**

(30) Priority: 30.01.2022 CN 202210114753
(71) Applicant: Huawei Digital Power Technologies Co., Ltd., Shenzhen, Guangdong 518043 (CN)
(72) Inventor: LIAN, Zhisheng, Shenzhen, Guangdong 518043 (CN); WEI, Longhe, Shenzhen, Guangdong 518043 (CN)
(74) Representative: Gill Jennings & Every LLP
(86) International application number: PCT/CN2023/072907
(87) International publication number: WO 2023/143309

(57) **Abstract**

This application relates to the field of heat dissipation technologies, and in particular, to a heat dissipation system, a power supply system, and a charging pile. The heat dissipation system includes a heat dissipation cavity, a first liquid cooling assembly, an air cooling assembly, a first power cavity, and a first power device. The first liquid cooling assembly and the first power cavity are disposed inside the heat dissipation cavity. The first power device is disposed inside the first power cavity. The first power cavity is in contact with the first liquid cooling assembly. An air inlet and an air outlet of the air cooling assembly are disposed on the heat dissipation cavity. An air-cooled channel connected between the air inlet and the air outlet passes through the first liquid cooling assembly and/or the first power cavity. The first liquid cooling assembly and the air cooling assembly are configured to dissipate heat for the first power device. Based on the heat dissipation system provided in this application, problems of low heat dissipation efficiency, poor reliability, and high maintenance costs in an existing heat dissipation system can be effectively resolved, and applicability of the heat dissipation system can be improved.

## Description

This application claims priority to Chinese Patent Application No. 202210114753.x, filed with the China National Intellectual Property Administration on January 30, 2022 and entitled "HEAT DISSIPATION SYSTEM, POWER SUPPLY SYSTEM, AND CHARGING PILE", which is incorporated herein by reference in its entirety.

### TECHNICAL FIELD

This application relates to the field of heat dissipation technologies, and in particular, to a heat dissipation system, a power supply system, and a charging pile.

### BACKGROUND

With continuous improvement of performance of a power-consuming device, power consumption of internal components of the device also continuously increases. Consequently, the power-consuming device generates a large amount of heat. Therefore, a heat dissipation system needs to be disposed for an existing high-power power-consuming device to dissipate heat, thereby ensuring working performance of the high-power power-consuming device. A common charging pile is used as an example. As a charging power and charging interfaces of the charging pile continuously increase, more heat is generated by the charging pile, and a corresponding heat dissipation system needs to be provided for normal operation.

Existing heat dissipation systems mainly include an air-cooled heat dissipation system and a liquid-cooled heat dissipation system. Because ventilation holes need to be disposed on the air-cooled heat dissipation system, a heat dissipation device and a power device inside the system cannot be effectively protected. As a result, reliability is poor, and maintenance costs are high. Further, devices such as a circulating water pump and a liquid pipe connector in the liquid-cooled heat dissipation system also result in poor reliability. In addition, because a coolant needs to be replaced periodically, maintenance costs are also high. Moreover, heat dissipation efficiency of the existing air-cooled heat dissipation system and heat dissipation efficiency of the existing liquid-cooled heat dissipation system further are low, and applicability is low. Therefore, a heat dissipation system that has high reliability and low maintenance costs needs to be proposed urgently.

### SUMMARY

To resolve the foregoing problem, this application provides a heat dissipation system, a power supply system, and a charging pile. The heat dissipation system has high heat dissipation efficiency, high reliability, relatively low maintenance costs, and relatively high applicability.

According to a first aspect, an embodiment of this application provides a heat dissipation system. The heat dissipation system includes a heat dissipation cavity, a first liquid cooling assembly, an air cooling assembly, a first power cavity, and a first power device. The first liquid cooling assembly and the first power cavity are disposed inside the heat dissipation cavity. The first power device is disposed inside the first power cavity. The first power cavity is in contact with the first liquid cooling assembly. An air inlet and an air outlet of the air cooling assembly are disposed on the heat dissipation cavity. Airflow in an air-cooled channel connected between the air inlet and the air outlet passes through the first liquid cooling assembly and/or the first power cavity. The first liquid cooling assembly and the air cooling assembly are configured to dissipate heat for the first power device.

In the foregoing implementation, the first liquid cooling assembly and the air cooling assembly are integrated in the heat dissipation cavity, and the first liquid cooling assembly is in direct contact with the first power cavity including the first power device, so that the airflow in the air-cooled channel corresponding to the air cooling assembly passes through the first liquid cooling assembly and/or the first power cavity. In this way, the first liquid cooling assembly and the air cooling assembly may simultaneously dissipate heat for the first power device, so that heat dissipation efficiency of the heat dissipation system is relatively high. In addition, the first power cavity is further used to protect the first power device, so that a fault of the first power device caused by factors such as an environment can be effectively avoided, reliability of the heat dissipation system can be improved, and subsequent maintenance costs can also be reduced. Therefore, the heat dissipation system has high applicability. Based on the heat dissipation system, problems of low heat dissipation efficiency, poor reliability, and high maintenance costs in an existing heat dissipation system can be effectively resolved.

With reference to the first aspect, in a feasible implementation, the first liquid cooling assembly includes a first condenser, a first evaporator, and a first heat conducting structure. The first condenser is disposed at a top of the heat dissipation cavity. The first evaporator is in contact with the first power cavity and is disposed below the first condenser. The first heat conducting structure connects the first evaporator and the first condenser to form a circulation loop. A cooling working substance circulating in the circulation loop is used to bring heat of the first evaporator to the first condenser.

In the foregoing implementation, the circulation loop that may be used for circulating flow of the cooling working substance is formed between the first condenser and the first evaporator through the first heat conducting structure, to implement a liquid-cooled heat dissipation function of the first liquid cooling assembly. In this way, the first liquid cooling assembly does not need to depend on mechanical parts such as a circulating water pump and a liquid pipe connector, so that problems of a high system failure rate, high subsequent maintenance costs, and the like of the heat dissipation system caused by these mechanical parts can be avoided, and reliability of the heat dissipation system can be effectively improved.

With reference to the first aspect, in a feasible implementation, a heat sink fin is disposed on a surface that is of the first power cavity and that is not in contact with the first evaporator.

In the foregoing implementation, the heat sink fin is disposed on the surface that is of the first power cavity and that is not in contact with the first evaporator. Heat dissipation of the first power cavity may be implemented through the heat sink fin, so that the heat dissipation efficiency of the heat dissipation system is further improved. In addition, the airflow flowing in the air-cooled channel may be further filtered through the heat sink fin, to reduce dust in the airflow, so that a content of dust entering the first condenser is small. Therefore, maintenance time of the first condenser may be prolonged, and maintenance costs of the heat dissipation system may be reduced.

With reference to the first aspect, in a feasible implementation, the air cooling assembly further includes a first fan. The air inlet and the first fan are disposed at a bottom of the heat dissipation cavity and are located below the first liquid cooling assembly. The air outlet is disposed at the top of the heat dissipation cavity. The first fan is configured to bring, through the air-cooled channel, airflow that enters the air inlet to the air outlet. The airflow in the air-cooled channel passes through the first condenser and the first power cavity, to bring heat of the first condenser and the first power cavity to the outside of the heat dissipation cavity. Alternatively, the first fan is configured to bring, through the air-cooled channel, airflow that enters the air inlet to the air outlet. The airflow in the air-cooled channel passes through the first condenser and the first evaporator, to bring heat of the first condenser and the first evaporator to the outside of the heat dissipation cavity.

In the foregoing implementation, the air inlet and the first fan of the air cooling assembly are disposed at the bottom, and the air outlet is disposed at the top, so that the air-cooled channel may pass through both the first condenser and the first evaporator or the first power cavity. Therefore, more efficient air-cooled heat dissipation for the first power device may be implemented, and the heat dissipation efficiency of the heat dissipation system may be effectively improved. In addition, because there is a specific height difference between the air inlet and the air outlet, dust removal may be performed on the airflow flowing in the air-cooled channel by using the height difference. Therefore, dust entering the first condenser is greatly reduced, the maintenance time of the first condenser 201 may be further prolonged, and the maintenance costs of the heat dissipation system may be reduced.

With reference to the first aspect, in a feasible implementation, the heat dissipation system further includes a second liquid cooling assembly that has a same structure as the first liquid cooling assembly, a second power cavity, and a second power device. A second condenser of the second liquid cooling assembly is disposed at the top of the heat dissipation cavity and is located on a side of the first liquid cooling assembly. The second power cavity is in contact with a second evaporator of the second liquid cooling assembly. The second power device is disposed inside the second power cavity. The airflow in the air-cooled channel further passes through the second condenser and the second power cavity, to bring heat of the second condenser and the second power cavity to the outside of the heat dissipation cavity. Alternatively, the airflow in the air-cooled channel further passes through the second condenser and the second evaporator, to bring heat of the second condenser and the second evaporator to the outside of the heat dissipation cavity.

In the foregoing implementation, the second liquid cooling assembly that has a same structure as the first liquid cooling assembly is further disposed inside the heat dissipation cavity. In addition, the second evaporator of the second liquid cooling assembly is further in contact with the second power cavity in which the second power device is disposed. In this way, the heat dissipation system can dissipate heat for both the first power device and the second power device through the first liquid cooling assembly, the air cooling assembly, and the second liquid cooling assembly, so that a load capability of the heat dissipation system is greater, and a heat dissipation capability and the applicability of the heat dissipation system may be improved.

With reference to the first aspect, in a feasible implementation, the air cooling assembly further includes a first fan. The air inlet is disposed at a bottom of the heat dissipation cavity and is located on a first side of the first liquid cooling assembly. The air outlet is disposed at the top of the heat dissipation cavity and is located on a second side that is of the first liquid cooling assembly and that is opposite to the first side. The first fan is disposed on the first side of the first liquid cooling assembly. The first fan is configured to bring, through the air-cooled channel, airflow that enters the air inlet to the air outlet. The airflow in the air-cooled channel passes through the first condenser and the first power cavity, to bring heat of the first condenser and the first power cavity to the outside of the heat dissipation cavity. Alternatively, the first fan is configured to bring, through the air-cooled channel, airflow that enters the air inlet to the air outlet. The airflow in the air-cooled channel passes through the first condenser and the first evaporator, to bring heat of the first condenser and the first evaporator to the outside of the heat dissipation cavity.

In the foregoing implementation, the air inlet is disposed at the bottom and is located on the first side of the first liquid cooling assembly. The air outlet is disposed at the top and is located on the second side that is of the first liquid cooling assembly and that is opposite to the first side. The first fan is disposed on a side that is of the first evaporator or the first power cavity and that faces the air inlet. In this way, the air-cooled channel can pass through both the first liquid cooling assembly and/or the first power cavity, so that efficient heat dissipation for the first power device may be implemented. In addition, because there is a specific height difference between the air inlet and the air outlet, dust removal may be performed on the airflow flowing in the air-cooled channel by using the height difference. Therefore, dust entering the first condenser is greatly reduced, the maintenance time of the first condenser may be further prolonged, and the maintenance costs of the heat dissipation system may be reduced. Moreover, the first fan is disposed on the side that is of the first evaporator or the first power cavity and that faces the air inlet, so that the height of the heat dissipation cavity may be further reduced, and the applicability of the heat dissipation system may be improved.

With reference to the first aspect, in a feasible implementation, the heat dissipation system further includes a second liquid cooling assembly, a second power cavity, and a second power device. A second condenser of the second liquid cooling assembly is disposed on a side that is of the first condenser and that faces the air outlet. The second power cavity is in contact with a second evaporator of the second liquid cooling assembly. The second power device is disposed inside the second power cavity. The airflow in the air-cooled channel further passes through the second condenser, to bring heat of the second condenser to the outside of the heat dissipation cavity.

In the foregoing implementation, the second liquid cooling assembly that has a same structure as the first liquid cooling assembly is further disposed inside the heat dissipation cavity. In addition, the second evaporator of the second liquid cooling assembly is further in contact with the second power cavity in which the second power device is disposed. In this way, the heat dissipation system can dissipate heat for both the first power device and the second power device through the first liquid cooling assembly, the air cooling assembly, and the second liquid cooling assembly, so that a load capability of the heat dissipation system is greater, and a heat dissipation capability and the applicability of the heat dissipation system may be improved.

With reference to the first aspect, in a feasible implementation, the air cooling assembly further includes a first fan, and the air inlet includes a first air inlet. The first air inlet, the air outlet, and the first fan are disposed at the top of the heat dissipation cavity. The first air inlet is disposed on a first side of the first condenser. The first fan is disposed on a second side that is of the first condenser and that is opposite to the first side. The air outlet is disposed on a side that is of the first fan and that faces away from the first condenser. The first fan is configured to bring, through the air-cooled channel, airflow that enters the first air inlet to the air outlet. The airflow in the air-cooled channel passes through the first condenser, to bring heat of the first condenser to the outside of the heat dissipation cavity.

In the foregoing implementation, the first air inlet, the air outlet, and the first fan may all be disposed at the top of the heat dissipation cavity. In this way, the air-cooled channel can pass through the first condenser, so that air-cooled heat dissipation for the first power device may be implemented. In addition, the first fan is disposed on one side of the first condenser, so that the height of the heat dissipation cavity may be reduced, and the applicability of the heat dissipation system may be improved.

With reference to the first aspect, in a feasible implementation, the heat dissipation system further includes a second liquid cooling assembly that has a same structure as the first liquid cooling assembly, a second power cavity, and a second power device. A second condenser of the second liquid cooling assembly is disposed on a side that is of the first fan and that faces the air outlet. The second power cavity is in contact with a second evaporator of the second liquid cooling assembly. The second power device is disposed inside the second power cavity. The airflow in the air-cooled channel further passes through the second condenser, to bring heat of the second condenser to the outside of the heat dissipation cavity.

In the foregoing implementation, the second liquid cooling assembly that has a same structure as the first liquid cooling assembly is further disposed inside the heat dissipation cavity. In this way, the heat dissipation system can dissipate heat for both the first power device and the second power device through the first liquid cooling assembly, the air cooling assembly, and the second liquid cooling assembly, so that a load capability of the heat dissipation system is greater, and a heat dissipation capability of the heat dissipation system may be improved. In addition, the first fan is further disposed between the first condenser and the second condenser, so that the height of the heat dissipation system may be reduced, and the applicability of the heat dissipation system may be improved.

With reference to the first aspect, in a feasible implementation, the heat dissipation system further includes a second liquid cooling assembly that has a same structure as the first liquid cooling assembly, a second power cavity, and a second power device. A second condenser of the second liquid cooling assembly is disposed on a side that is of the first condenser and that faces away from the air outlet. The second power cavity is in contact with a second evaporator of the second liquid cooling assembly. The second power device is disposed inside the second power cavity. The airflow in the air-cooled channel further passes through the second condenser, to bring heat of the second condenser to the outside of the heat dissipation cavity.

In the foregoing implementation, the second liquid cooling assembly that has a same structure as the first liquid cooling assembly is further disposed inside the heat dissipation cavity. In this way, the heat dissipation system can dissipate heat for both the first power device and the second power device through the first liquid cooling assembly, the air cooling assembly, and the second liquid cooling assembly, so that a load capability of the heat dissipation system is greater, and a heat dissipation capability of the heat dissipation system may be improved. In addition, the first fan is further disposed on the side that is of the first condenser and that faces away from the second condenser, so that the height of the heat dissipation system is reduced, and subsequent maintenance of the first fan is also facilitated.

With reference to the first aspect, in a feasible implementation, a first air baffle is disposed between a first cavity and a second cavity of the heat dissipation cavity. The first air baffle is configured to block ventilation between the first cavity and the second cavity. The first cavity is a cavity that is included in the heat dissipation cavity and that is located on a side that is of the first condenser and that faces the air outlet. The second cavity is a cavity that is included in the heat dissipation cavity and that is located on a side that is of the first power cavity or the first evaporator and that faces away from the second liquid cooling assembly.

In the foregoing implementation, the first air baffle can prevent the first fan from blowing air in the second cavity to the air outlet, to ensure that most of the airflow in the air-cooled channel flows through the first condenser and the second condenser. In this way, heat dissipation efficiency of the air cooling assembly for the first condenser and the second condenser can be ensured.

With reference to the first aspect, in a feasible implementation, the air cooling assembly further includes a first fan, and the air outlet includes a first air outlet. The air inlet is disposed at a bottom of the heat dissipation cavity. The first air outlet is disposed at the top of the heat dissipation cavity. The first fan is disposed on a side that is of the first condenser and that faces the first air outlet. A first air baffle is disposed between a first cavity and a second cavity of the heat dissipation cavity. The first air baffle is configured to block ventilation between the first cavity and the second cavity. The first cavity is a cavity that is included in the heat dissipation cavity and that is located on the side that is of the first condenser and that faces the first air outlet. The second cavity is a cavity that is included in the heat dissipation cavity and that is located on a side that is of the first power cavity or the first evaporator and that faces away from a second liquid cooling assembly. The first fan is configured to bring, through the air-cooled channel, airflow that enters the air inlet to the first air outlet. The airflow in the air-cooled channel passes through the first condenser and the first evaporator, to bring heat of the first condenser and the first evaporator to the outside of the heat dissipation cavity. Alternatively, the first fan is configured to bring, through the air-cooled channel, airflow that enters the air inlet to the first air outlet. The airflow in the air-cooled channel passes through the first condenser and the first power cavity, to bring heat of the first condenser and the first cavity to the outside of the heat dissipation cavity.

In the foregoing implementation, the air inlet is disposed at the bottom, the first air outlet is disposed at the top, and the first fan is disposed on the side that is of the first condenser and that faces the first air outlet. In this way, the air-cooled channel can pass through the first liquid cooling assembly and/or the first power cavity, so that efficient heat dissipation for the first power device may be implemented. In addition, because there is a specific height difference between the air inlet and the first air outlet, dust removal may be performed on the airflow flowing in the air-cooled channel by using the height difference. Therefore, dust entering the first condenser is greatly reduced, the maintenance time of the first condenser may be further prolonged, and the maintenance costs of the heat dissipation system may be reduced. Moreover, the first fan is disposed on a side surface of the first condenser, so that the height of the heat dissipation cavity may be further reduced, and the applicability of the heat dissipation system is improved.

With reference to the first aspect, in a feasible implementation, the heat dissipation system further includes a second liquid cooling assembly that has a same structure as the first liquid cooling assembly, a second power cavity, and a second power device. The air cooling assembly further includes a second fan. The air outlet further includes a second air outlet. A second condenser of the second liquid cooling assembly is disposed on a side that is of the first condenser and that faces away from the first fan. The second power cavity is in contact with a second evaporator of the second liquid cooling assembly. The second power device is disposed inside the second power cavity. The second fan is located on a side that is of the second condenser and that faces away from the first condenser. The second air outlet is disposed at the top of the heat dissipation cavity. A second air baffle is disposed between a third cavity and a fourth cavity of the heat dissipation cavity. The second air baffle is configured to block ventilation between the third cavity and the fourth cavity. The third cavity is a cavity that is included in the heat dissipation cavity and that is located on a side that is of the second condenser and that faces the second air outlet. The fourth cavity is a cavity that is included in the heat dissipation cavity and that is located on a side that is of the second power cavity and the second evaporator and that faces away from the first liquid cooling assembly. The second fan is configured to bring, through the air-cooled channel, airflow that enters the air inlet to the second air outlet. The airflow in the air-cooled channel further passes through the second condenser and the second evaporator, to bring heat of the second condenser and the second evaporator to the outside of the heat dissipation cavity. Alternatively, the second fan is configured to bring, through the air-cooled channel, airflow that enters the air inlet to the second air outlet. The airflow in the air-cooled channel passes through the second condenser and the second power cavity, to bring heat of the second condenser and the second cavity to the outside of the heat dissipation cavity.

In the foregoing implementation, the second liquid cooling assembly that has a same structure as the first liquid cooling assembly is further disposed inside the heat dissipation cavity, and the second fan and the second air outlet are additionally disposed. In this way, the heat dissipation system can dissipate heat more effectively for both the first power device and the second power device through the first liquid cooling assembly, the air cooling assembly, and the second liquid cooling assembly, so that a load capability of the heat dissipation system is greater, and a heat dissipation capability of the heat dissipation system is stronger. In addition, the first fan and the second fan are respectively disposed on outer sides of the condensers, so that the height of the heat dissipation system is reduced, and subsequent maintenance of the fans is also facilitated.

With reference to the first aspect, in a feasible implementation, the air cooling assembly further includes a first fan, and the air inlet includes a first air inlet. The first fan is disposed above the first liquid cooling assembly. The first air inlet is disposed on a side surface of the first condenser. The air outlet is disposed on a side surface of the first fan. The fan is configured to bring, through the air-cooled channel, airflow that enters the first air inlet to the air outlet. The airflow in the air-cooled channel passes through the first condenser, to bring heat of the first condenser to the outside of the heat dissipation cavity.

In the foregoing implementation, the first fan is disposed above the first condenser, the first air inlet is disposed on the side surface of the first condenser, and the air outlet is disposed on the side surface of the first fan. In this way, the airflow in the air-cooled channel can be in full contact with the first condenser, and efficient air-cooled heat dissipation for the first condenser can be implemented. In addition, based on such a structure, subsequent maintenance of the first fan can also be facilitated.

With reference to the first aspect, in a feasible implementation, the heat dissipation system further includes a second liquid cooling assembly, a second power cavity, and a second power device. A second condenser of the second liquid cooling assembly is disposed on a side of the first condenser. The second power cavity is in contact with a second evaporator of the second liquid cooling assembly. The second power device is disposed inside the second power cavity. The airflow in the air-cooled channel further passes through the second condenser, to bring heat of the second condenser to the outside of the heat dissipation cavity.

In the foregoing implementation, the second liquid cooling assembly that has a same structure as the first liquid cooling assembly is further disposed inside the heat dissipation cavity. In this way, the heat dissipation system can dissipate heat for both the first power device and the second power device through the first liquid cooling assembly, the air cooling assembly, and the second liquid cooling assembly, so that a load capability of the heat dissipation system is greater, and a heat dissipation capability of the heat dissipation system may be improved.

With reference to the first aspect, in a feasible implementation, the air cooling assembly further includes a second air inlet. The second air inlet is disposed at a bottom of the heat dissipation cavity. The first fan is further configured to bring, through the air-cooled channel, airflow that enters the second air inlet to the air outlet. The airflow in the air-cooled channel further passes through the first power cavity and the second power cavity, to bring heat of the first power cavity and the second power cavity to the outside of the heat dissipation cavity.

In the foregoing implementation, after the second air inlet is additionally disposed at the bottom, the air-cooled channel passes through the first condenser and the second condenser, and further passes through any two of the first power cavity, the second power cavity, the first evaporator, and the second evaporator. In this way, the air cooling assembly can perform air-cooled heat dissipation on the first condenser and the second condenser, and can further perform heat dissipation on any two of the first power cavity, the second power cavity, the first evaporator, and the second evaporator, thereby effectively improving heat dissipation efficiency of the heat dissipation system.

With reference to the first aspect, in a feasible implementation, the heat dissipation system further includes a third liquid cooling assembly that has a same structure as the first liquid cooling assembly, a third power cavity, and a third power device. A third condenser of the third liquid cooling assembly is disposed below the first liquid cooling assembly. The third power cavity is in contact with a third evaporator of the third liquid cooling assembly. The third power device is disposed inside the third power cavity. The airflow in the air-cooled channel further passes through the third condenser and the third evaporator, to bring heat of the third condenser and the third evaporator to the outside of the heat dissipation cavity. Alternatively, the airflow in the air-cooled channel further passes through the third condenser and the third power cavity, to bring heat of the third condenser and the third power cavity to the outside of the heat dissipation cavity.

In the foregoing implementation, the third liquid cooling assembly that has a same structure as the first liquid cooling assembly is further disposed inside the heat dissipation cavity. In addition, the third liquid cooling assembly and the first liquid cooling assembly are placed inside the heat dissipation cavity in a stacked structure. Based on such a structure design, internal space of the heat dissipation cavity can be effectively utilized. In addition, the heat dissipation system can dissipate heat for the first power device, the second power device, and the third power device in combination with the first liquid cooling assembly, the air cooling assembly, the second liquid cooling assembly, and the third liquid cooling assembly, thereby further improving the load capability of the heat dissipation system.

With reference to the first aspect, in a feasible implementation, the air cooling assembly further includes a third air inlet. The third air inlet is disposed on a side surface of the third condenser.

In the foregoing implementation, the third air inlet is additionally disposed, so that an air intake volume of the air-cooled channel may be further increased, a heat dissipation capability of the air cooling assembly is improved, and then heat dissipation efficiency of the heat dissipation system is improved.

With reference to the first aspect, in a feasible implementation, the air cooling assembly further includes a first fan. The air inlet is disposed on a side surface of the first condenser. The air outlet and the first fan are disposed at a bottom of the heat dissipation cavity and are located below the first liquid cooling assembly. The first fan is configured to bring, through the air-cooled channel, airflow that enters the air inlet to the air outlet. The airflow in the air-cooled channel passes through the first condenser and the first evaporator, to bring heat of the first condenser and the first evaporator to the outside of the heat dissipation cavity. Alternatively, the first fan is configured to bring, through the air-cooled channel, airflow that enters the air inlet to the air outlet. The airflow in the air-cooled channel passes through the first condenser and the first power cavity, to bring heat of the first condenser and the first cavity to the outside of the heat dissipation cavity.

In the foregoing implementation, the first fan and the air outlet are disposed below the first liquid cooling assembly, and the air inlet is disposed on the side surface of the first condenser. In this way, the air-cooled channel may pass through the first condenser and further pass through the first power cavity or the first evaporator. Therefore, the air cooling assembly can not only dissipate heat for the first condenser, but also dissipate heat for the first power cavity or the first evaporator, thereby improving heat dissipation efficiency of the heat dissipation system.

With reference to the first aspect, in a feasible implementation, the heat dissipation system further includes a second liquid cooling assembly, a second power cavity, and a second power device. A second condenser of the second liquid cooling assembly is disposed on a side surface of the first condenser. The second power cavity is in contact with the second evaporator. The second power device is disposed inside the second power cavity. The second fan is configured to bring, through the air-cooled channel, airflow that enters the air inlet to the second air outlet. The airflow in the air-cooled channel further passes through the second condenser and the second evaporator, to bring heat of the second condenser and the second evaporator to the outside of the heat dissipation cavity. Alternatively, the second fan is configured to bring, through the air-cooled channel, airflow that enters the air inlet to the second air outlet. The airflow in the air-cooled channel passes through the second condenser and the second power cavity, to bring heat of the second condenser and the second cavity to the outside of the heat dissipation cavity.

In the foregoing implementation, the second liquid cooling assembly that has a same structure as the first liquid cooling assembly is further disposed inside the heat dissipation cavity. In this way, the heat dissipation system can dissipate heat for both the first power device and the second power device through the first liquid cooling assembly, the air cooling assembly, and the second liquid cooling assembly, so that a load capability of the heat dissipation system is higher, and a heat dissipation capability of the heat dissipation system may be improved.

According to a second aspect, an embodiment of this application provides a power supply system. The power supply system includes a power supply, the heat dissipation system according to the first aspect and any one of the possible implementations of the first aspect, and a load. A power device in the heat dissipation system is connected to both the power supply and the load. The heat dissipation system is configured to dissipate heat for the power device. The power device is configured to: convert initial electric energy provided by the power supply into target electric energy, and supply power to the load by using the target electric energy.

In the foregoing implementation, the heat dissipation system according to the first aspect is used in the power supply system, to ensure security and reliability of the power supply system.

According to a third aspect, an embodiment of this application further provides a charging pile. The charging pile includes a first electrical interface, a second electrical interface, and the heat dissipation system according to the first aspect and any one of the possible implementations of the first aspect. A power device in the heat dissipation system is connected to both a first power supply interface and a second power supply interface. The heat dissipation system is configured to dissipate heat for the power device. The power device is configured to: convert initial electric energy input by the first electrical interface into target electric energy, and output the target electric energy through the second electrical interface.

With reference to the third aspect, in a feasible implementation, the power device is a DC/DC conversion module or an AC/DC conversion module.

With reference to the third aspect, in a feasible implementation, the first electrical interface is connected to a power supply, and the second electrical interface is connected to a load.

With reference to the third aspect, in a feasible implementation, the power supply is an alternating current power grid or a photovoltaic array, and the load is an electric vehicle or a robot.

Based on the heat dissipation system, the power supply system, and the charging pile provided in embodiments of this application, problems of low heat dissipation efficiency, poor reliability, and high maintenance costs in an existing heat dissipation system can be effectively resolved. The heat dissipation system provided in this application has high heat dissipation efficiency, high reliability, low maintenance costs, and better applicability.

### BRIEF DESCRIPTION OF DRAWINGS

FIG. 1 is a schematic diagram of a structure of a heat dissipation system according to an embodiment of this application;
FIG. 2(a) to FIG. 2(c) are schematic diagrams of another structure of a heat dissipation system according to an embodiment of this application;
FIG. 3 is a schematic diagram of another structure of a heat dissipation system according to an embodiment of this application;
FIG. 4 is a schematic diagram of another structure of a heat dissipation system according to an embodiment of this application;
FIG. 5 is a schematic diagram of another structure of a heat dissipation system according to an embodiment of this application;
FIG. 6 is a schematic diagram of another structure of a heat dissipation system according to an embodiment of this application;
FIG. 7 is a schematic diagram of another structure of a heat dissipation system according to an embodiment of this application;
FIG. 8 is a schematic diagram of locations of an air inlet and an air outlet according to an embodiment of this application;
FIG. 9 is a schematic diagram of another structure of a heat dissipation system according to an embodiment of this application;
FIG. 10 is a schematic diagram of another structure of a heat dissipation system according to an embodiment of this application;
FIG. 11 is a schematic diagram of another structure of a heat dissipation system according to an embodiment of this application;
FIG. 12 is a schematic diagram of another structure of a heat dissipation system according to an embodiment of this application;
FIG. 13 is a schematic diagram of another structure of a heat dissipation system according to an embodiment of this application;
FIG. 14 is a schematic diagram of another structure of a heat dissipation system according to an embodiment of this application;
FIG. 15 is a schematic diagram of another structure of a heat dissipation system according to an embodiment of this application;
FIG. 16 is a schematic diagram of another structure of a heat dissipation system according to an embodiment of this application;
FIG. 17 is a schematic diagram of another structure of a heat dissipation system according to an embodiment of this application;
FIG. 18 is a schematic diagram of another structure of a heat dissipation system according to an embodiment of this application;
FIG. 19 is a schematic diagram of another structure of a heat dissipation system according to an embodiment of this application;
FIG. 20 is a schematic diagram of another structure of a heat dissipation system according to an embodiment of this application;
FIG. 21 is a schematic diagram of another structure of a heat dissipation system according to an embodiment of this application;
FIG. 22 is a schematic diagram of another structure of a heat dissipation system according to an embodiment of this application;
FIG. 23 is a schematic diagram of another structure of a heat dissipation system according to an embodiment of this application;
FIG. 24 is a schematic diagram of another structure of a heat dissipation system according to an embodiment of this application;
FIG. 25 is a schematic diagram of an application scenario according to an embodiment of this application;
FIG. 26 is a schematic diagram of a structure of a power supply system according to an embodiment of this application; and
FIG. 27 is a schematic diagram of a structure of a charging pile according to an embodiment of this application.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

As a power of a power-consuming device continuously increases, a heat dissipation system has become a necessary assembly. Existing heat dissipation systems mainly include an air-cooled heat dissipation system and a liquid-cooled heat dissipation system. However, the two heat dissipation systems generally have problems of low heat dissipation efficiency, poor reliability, high maintenance costs, and the like. As a result, applicability is poor.

Therefore, a technical problem to be resolved in this application is how to provide a heat dissipation system having high heat dissipation efficiency, high reliability, and low maintenance costs, to improve applicability of the heat dissipation system.

To resolve the foregoing problem, this application provides a heat dissipation system. A liquid cooling assembly, an air cooling assembly, and a power cavity are disposed inside a heat dissipation cavity of the heat dissipation system. In addition, a power device is disposed inside the power cavity. The power cavity is in contact with the liquid cooling assembly. An air inlet and an air outlet of the air cooling assembly are disposed on the heat dissipation cavity. Airflow in an air-cooled channel connected between the air inlet and the air outlet passes through a first liquid cooling assembly and/or a first power cavity, to dissipate heat. The heat dissipation system combines the air cooling assembly and the liquid cooling assembly, so that heat dissipation efficiency is high. In addition, the power cavity is used to protect the power device that generates heat, so that a fault of the power device caused by factors such as an environment can be effectively avoided, reliability of the heat dissipation system can be improved, and subsequent maintenance costs can also be reduced. Therefore, based on the heat dissipation system, the problems of low heat dissipation efficiency, poor reliability, high maintenance costs, and the like in the existing heat dissipation system can be effectively resolved, and the applicability of the heat dissipation system can be effectively improved.

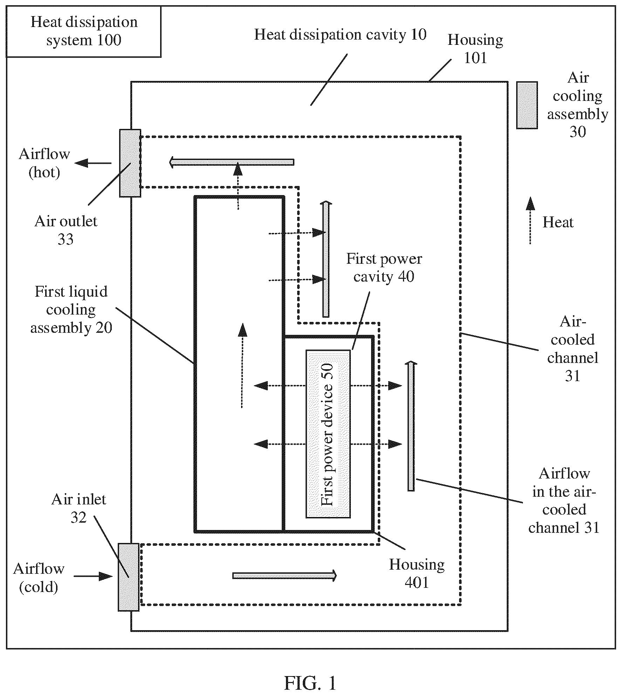

FIG. 1 is a schematic diagram of a structure of a heat dissipation system according to an embodiment of this application. As shown in FIG. 1, the heat dissipation system 100 may include a heat dissipation cavity 10, a first liquid cooling assembly 20, an air cooling assembly 30, a first power cavity 40, and a first power device 50. The first liquid cooling assembly 20 and the first power cavity 40 are disposed inside the heat dissipation cavity 10. In addition, the first liquid cooling assembly 20 is in contact with the first power cavity 40, and the first power device 50 may be disposed inside the first power cavity 40. Moreover, an air inlet 32 and an air outlet 33 of the air cooling assembly 30 are further disposed on the heat dissipation cavity 10. An air-cooled channel 31 that corresponds to the air cooling assembly 30 and that is connected between the air inlet 32 and the air outlet 33 is also disposed inside the heat dissipation cavity 10, and airflow in the air-cooled channel 31 passes through the first liquid cooling assembly 20 and/or the first power cavity 40.

It should be noted that each of the heat dissipation cavity 10 and the first power cavity 40 described above is a structure that is formed by a closed housing and that includes a cavity in a fixed shape. As shown in FIG. 1, the heat dissipation cavity 10 is a structure that is formed by a closed housing 101 and that includes a cavity. The first power cavity 40 is a structure that is formed by a closed housing 401 and that includes a cavity. In actual implementation, a shape of the housing 101 of the heat dissipation cavity 10 (which may also be understood as a shape of the heat dissipation cavity 10) may be a cuboid, a cylinder, or the like, and a shape of the housing 401 of the first power cavity 40 (which may also be understood as a shape of the first power cavity 40) may also be a cuboid, a cylinder, or the like. The shapes of these cavities may be set based on a specific requirement. This is not limited in this application. Herein, for ease of description of a structure of the heat dissipation system 100, an example in which the heat dissipation cavity 10 and the first power cavity 40 are cuboid cavities is used for description in the following.

It should be further noted herein that, the air-cooled channel 31 described above is a main path through which airflow that flows in through the air inlet 32 and flows out through the air outlet 33 passes. A specific location of the air-cooled channel 31 is mainly determined by a location of a fan included in the air cooling assembly 30 and locations of the air inlet 32 and the air outlet 33 on the heat dissipation cavity 10. The airflow in the air-cooled channel 31 described above passes through the first liquid cooling assembly 20 and/or the first power cavity 40. It may be alternatively understood that the air-cooled channel 31 passes through the first liquid cooling assembly 20 and/or the first power cavity 40. In other words, a case described in the following that the air-cooled channel 31 passes through a device or a structure is equivalent to a case that the airflow in the air-cooled channel 31 passes through the device or the structure. The distinction between the two description manners is not made again in the following. Moreover, that the air inlet 32 and the air outlet 33 of the air cooling assembly 30 described above are disposed on the heat dissipation cavity 10 may also be understood as that the air inlet 32 and the air outlet 33 are disposed on the housing 101 of the heat dissipation cavity 10. It should be understood herein that the locations of the air inlet 32 and the air outlet 33 and the location of the air-cooled channel 31 shown in FIG. 1 are merely examples. In actual implementation, the air inlet 32, the air outlet 33, and the air-cooled channel 31 may be alternatively disposed at other locations, provided that the airflow in the air-cooled channel 31 can be ensured to pass through the first liquid cooling assembly 20 and/or the first power cavity 40.

In actual working, both the first liquid cooling assembly 20 and the air cooling assembly 30 are configured to dissipate heat for the first power device 50. Specifically, the first power device 50 generates heat when working, and the heat is diffused to the outside of the first cavity 40 through the housing 401. Because the first power cavity 40 is in direct contact with the first liquid cooling assembly 20, a part of the heat generated by the first power device 50 is diffused to the first liquid cooling assembly 20 through a surface that is of the housing 401 and that is in contact with the first liquid cooling assembly 20, and the first liquid cooling assembly 20 may dissipate the heat in a liquid cooling manner. Further, when the air-cooled channel 31 passes through both the first liquid cooling assembly 20 and the first power cavity 40 (which may be understood as that the air-cooled channel 31 passes through the first liquid cooling assembly 20 and the first power cavity 40), because a part of a body of the first liquid cooling assembly 20 and a part of a body of the first power cavity 40 are in contact with the air-cooled channel 31, the airflow flowing in the air-cooled channel 31 may bring heat of the first liquid cooling assembly 20 and the first power cavity 40 to the outside of the heat dissipation cavity 10 for dissipation. Therefore, air-cooled heat dissipation for the first power device 50 is implemented. When the air-cooled channel 31 passes through only the first liquid cooling assembly 20, the airflow flowing in the air-cooled channel 31 may bring heat of the first liquid cooling assembly 20 to the outside of the heat dissipation cavity 10 for dissipation. Therefore, air-cooled heat dissipation for the first power device 50 is implemented.

In the foregoing implementation, the first liquid cooling assembly 20 and the air cooling assembly 30 are integrated in the heat dissipation cavity 10. The first liquid cooling assembly 20 is in direct contact with the first power cavity 40 including the first power device 50. The air-cooled channel 31 corresponding to the air cooling assembly 30 is designed as passing through the first liquid cooling assembly 20 and/or the first power cavity 40. In this way, the first liquid cooling assembly 20 and the air cooling assembly 30 may simultaneously dissipate heat for the first power device 50, so that heat dissipation efficiency of the heat dissipation system 100 may be relatively high. In addition, the first power cavity 40 is further used to protect the first power device 50, so that a fault of the first power device 50 caused by factors such as an environment can be effectively avoided, reliability of the heat dissipation system 100 can be improved, and subsequent maintenance costs can also be reduced. Therefore, the heat dissipation system 100 has high applicability. Based on the heat dissipation system 100, problems of low heat dissipation efficiency, poor reliability, and high maintenance costs in an existing heat dissipation system can be effectively resolved.

The following describes in detail the structure and a function of the heat dissipation system 100 in combination with a plurality of optional structures of the liquid cooling assembly, the air cooling assembly, the power cavity, and the power device that are included in the heat dissipation system 100.

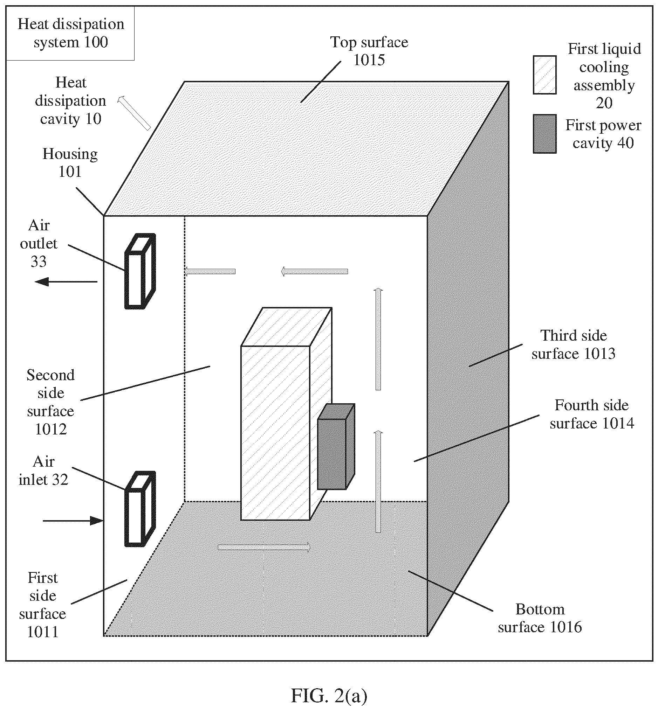

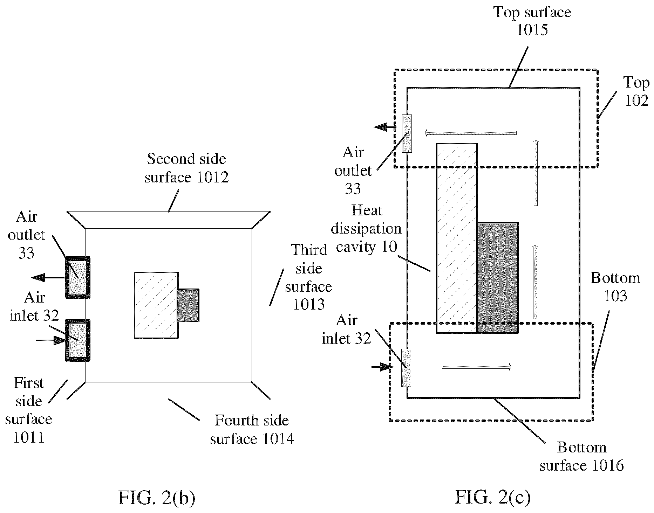

For ease of description of the structure of the heat dissipation system 100 in the following, a structure of the heat dissipation cavity 10 is first specifically described herein. FIG. 2(a) to FIG. 2(c) are schematic diagrams of another structure of a heat dissipation system according to an embodiment of this application. It should be understood that FIG. 2(a) is a sectional view of the heat dissipation cavity 10, FIG. 2(b) is a top view of the heat dissipation cavity 10, and FIG. 2(c) is a front view of the heat dissipation cavity 10. As shown in FIG. 2(a) to FIG. 2(c), it is assumed that the shape of the housing 101 of the heat dissipation cavity 10 is a cuboid. Four side surfaces are disposed on the housing 101, including a first side surface 1011, a second side surface 1012, a third side surface 1013, and a fourth side surface 1014 that are shown in FIG. 2(a) to FIG. 2(c). As shown in FIG. 2(b), the first side surface 1011 and the third side surface 1013 are opposite side surfaces, and the second side surface 1012 and the fourth side surface 1014 are opposite side surfaces. Moreover, the housing 101 further includes a top surface 1015 and a bottom surface 1016. Further, as shown in FIG. 2(c), in this application, a part that is of the heat dissipation cavity 10 and that includes the top surface 1015 is defined as a top 102 of the heat dissipation cavity 10, and a part that is of the heat dissipation cavity 10 and that includes the bottom surface 1016 and a part of the side surfaces is defined as a bottom 103 of the heat dissipation cavity 10.

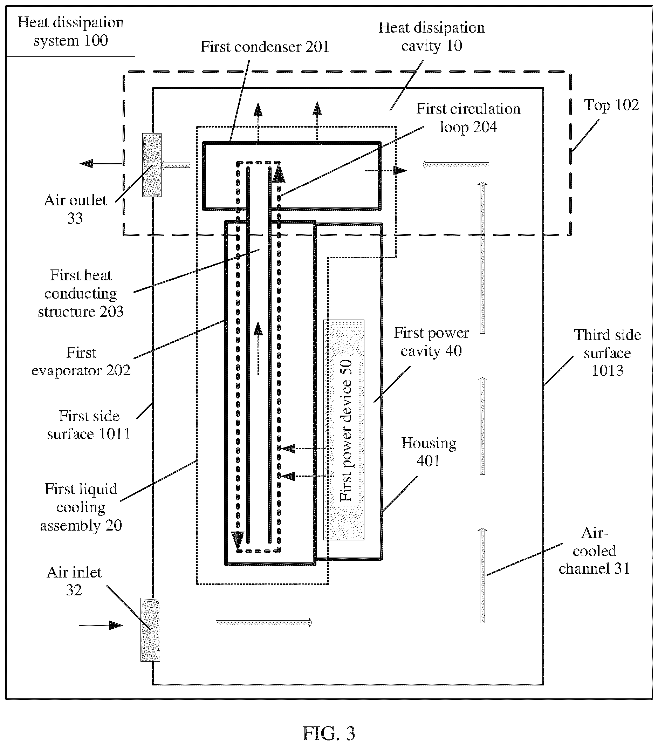

In some feasible implementations, FIG. 3 is a schematic diagram of another structure of a heat dissipation system according to an embodiment of this application. As shown in FIG. 3, the first liquid cooling assembly 20 may include a first condenser 201, a first evaporator 202, and a first heat conducting structure 203. The first condenser 201 is connected to the first evaporator 202 through the first heat conducting structure 203. The first condenser 201 is disposed at the top 102 of the heat dissipation cavity 102. It should be understood herein that the first condenser 201 may be actually disposed at any location of the part, included in the top 102, of the cavity, provided that the first condenser 201 is disposed inside the part of the cavity. A specific location may be disposed based on an actual requirement. This is not specifically limited herein. The first power cavity 40 is in contact with the first evaporator 202. It should be noted herein that, that the first power cavity 40 is in contact with the first evaporator 202 means that a part of a surface of the first power cavity 40 is attached to a part of a surface of the first evaporator 202. In this way, heat generated by the first power device 50 can be conducted to the first evaporator 202 through the first power cavity 40. It should be understood that, to improve direct heat conduction efficiency between the first power cavity 40 and the first evaporator 202, it is possible to ensure that a surface that is of the first power cavity 40 and that is in contact with the first evaporator 202 is large enough. For example, both the first power cavity 40 and the first evaporator 202 may be designed as cuboid structures, and a side surface of the first power cavity 40 and a side surface of the first evaporator 202 are in contact with each other. Moreover, both the first power cavity 40 and the first evaporator 202 are disposed below the first condenser 201. It should be understood herein that in actual implementation, the first power cavity 40 and the first evaporator 202 may be disposed directly below the first condenser 201, or may be disposed diagonally below the first condenser 201, provided that in a direction of a long side of the heat dissipation cavity 10, the first power cavity 40 and the first evaporator 202 are closer to the bottom 103 of the heat dissipation cavity 10 compared with the first condenser 201.

In actual working, both the first condenser 201 and the first evaporator 202 are filled with a cooling working substance. The first condenser 201 and the first evaporator 202 form a circulation loop (referred to as a first circulation loop 204 in the following descriptions for ease of distinction) through the first heat conducting structure 302. The cooling working substance may circulate between the first condenser 201 and the first evaporator 202 through the first circulation loop 204, to bring heat of the first evaporator 202 to the first condenser 201 for dissipation. Specifically, the first evaporator 202 absorbs a specific amount of heat from the first power cavity 40. The cold working substance in the first evaporator 202 vaporizes under an action of the heat. The vaporized cooling working substance reaches the first condenser 201 through the first heat conducting structure 203, to bring the heat of the first evaporator 202 to the first condenser 201. In addition, the cooling working substance in a vapor state dissipates the heat and condenses at the first condenser 201, changes back to the liquid-state cooling working substance, and flows back to the first evaporator 202 through the first heat conducting structure 203. In short, the first circulation loop 204 is formed through the first heat conducting structure 203, so that the cooling working substance can circulate between the first condenser 201 and the first evaporator 202, thereby implementing liquid-cooled heat dissipation for the first power cavity 40.

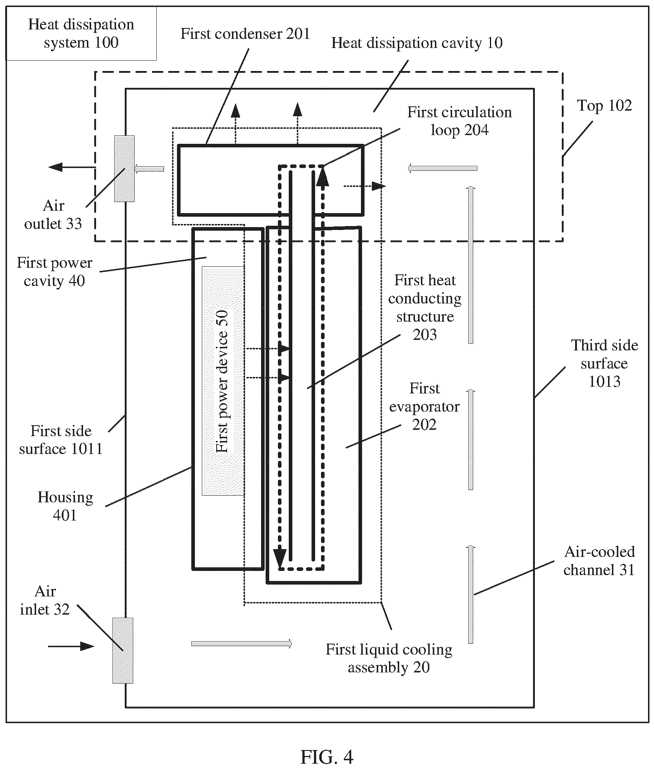

It should be noted herein that, in the structure shown in FIG. 3, the first power cavity 40 is disposed on a side that is of the first evaporator 202 and that faces the third side surface 1013. In this case, the air-cooled channel 31 passes through the first power cavity 40 and the first condenser 201. In another optional implementation, FIG. 4 is a schematic diagram of another structure of a heat dissipation system according to an embodiment of this application. As shown in FIG. 4, the first power cavity 40 may be alternatively disposed on a side that is of the first evaporator 202 and that faces the first side surface 1011. In this case, the air-cooled channel 31 passes through the first condenser 201 and the first evaporator 202, but does not pass through the first power cavity 40. It should be understood herein that, for the heat dissipation system 100, whether the first power cavity 40 and the first evaporator 202 are disposed based on a location relationship shown in FIG. 3 or a location relationship shown in FIG. 4 makes no difference to a function that can be implemented by the heat dissipation system 100. In addition, a structure and a function of another device in the heat dissipation system 100 are not affected. Therefore, to avoid repetition, the following further describes the structure and the function of the heat dissipation system 100 mainly by using the location relationship between the first power cavity 40 and the first evaporator 202 shown in FIG. 3 as an example.

In the foregoing implementation, the first circulation loop 204 that may be used for circulating flow of the cooling working substance is formed between the first condenser 201 and the first evaporator 202 through the first heat conducting structure 203, to implement a liquid-cooled heat dissipation function of the first liquid cooling assembly 20. In this way, the first liquid cooling assembly 20 does not need to depend on mechanical parts such as a circulating water pump and a liquid pipe connector, so that problems of a high system failure rate, high subsequent maintenance costs, and the like of the heat dissipation system 100 caused by these mechanical parts can be avoided, and reliability of the heat dissipation system 100 can be effectively improved.

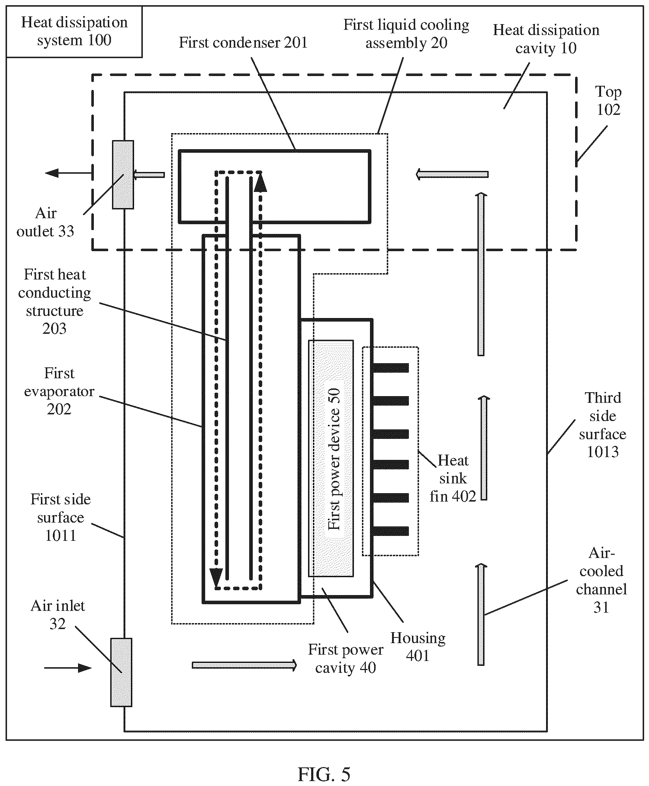

Further, optionally, FIG. 5 is a schematic diagram of another structure of a heat dissipation system according to an embodiment of this application. As shown in FIG. 5, heat sink fins 402 are disposed on a surface that is of the first power cavity 40 and that is not in contact with the first evaporator 202. In other words, heat sink fins 402 are disposed on a part or all of a surface that is of the housing 401 and that is not in contact with the first evaporator 202. In addition, the air-cooled channel 31 also passes through the heat sink fins 402. In actual working, the heat sink fins 402 may be configured to dissipate heat for the first power cavity 40. It should be understood herein that, as shown in FIG. 4, the heat sink fins are disposed only on the surface that is of the first power cavity 40 and that faces away from the first evaporator 202. In actual implementation, the heat sink fins may alternatively be disposed on other surfaces that are of the first power cavity 40 and that are not in contact with the first evaporator 202. For example, the heat sink fins may also be disposed on a top surface and a bottom surface of the first power cavity 40. A specific case may be determined based on an actual application requirement. This is not specifically limited in this application.

In the foregoing implementation, the heat sink fins 402 are disposed on the surface that is of the first power cavity 40 and that is not in contact with the first evaporator 202. Heat dissipation of the first power cavity 40 may be implemented through the heat sink fins 402, to further improve the heat dissipation efficiency of the heat dissipation system 100. In addition, the heat sink fins 402 may further filter the airflow flowing in the air-cooled channel 31 to reduce dust in the airflow, so that a content of dust entering the first condenser 201 is small. Therefore, maintenance time of the first condenser 201 may be prolonged, and maintenance costs of the heat dissipation system 100 may be reduced.

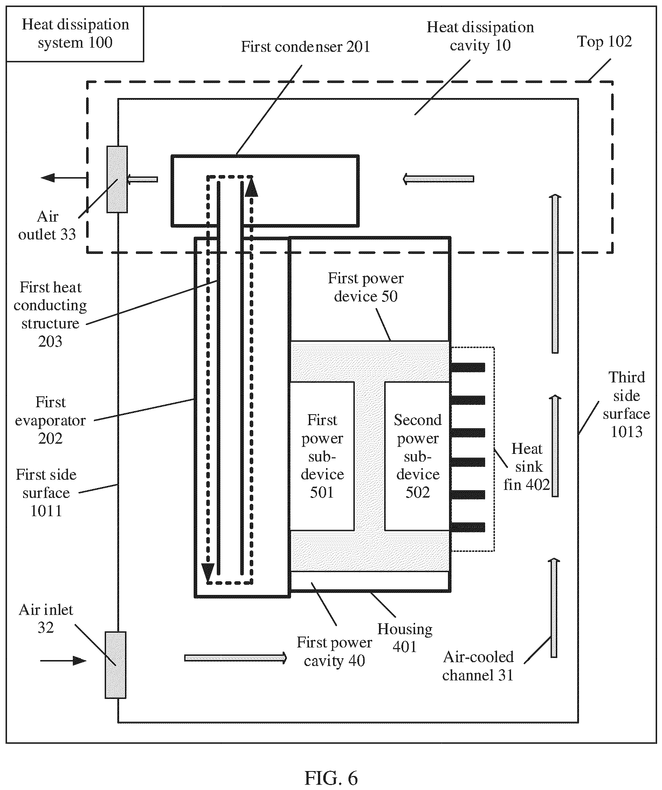

Further, optionally, FIG. 6 is a schematic diagram of another structure of a heat dissipation system according to an embodiment of this application. As shown in FIG. 6, the first power device 50 may specifically include a first power sub-device 501 and a second power sub-device 502. The first power sub-device 501 may be disposed on a side that is of the first power cavity 40 and that is in contact with the first evaporator 202. It may be alternatively understood that the first power sub-device 501 is attached to the first evaporator 202 through a side wall of the housing 401. The second power sub-device 502 may be disposed on a side that is of the first power cavity 40 and that has the heat sink fins 402. It may be alternatively understood that the second power sub-device 502 is attached to a side wall that is of the housing 401 and that has the heat sink fins 402. In actual use, the first power sub-device 501 may be a power device that has a relatively high heat dissipation requirement. The second power sub-device 502 may be a power device that has a relatively low heat dissipation requirement or is unable to be attached to the first evaporator 202 due to a space limitation. In this implementation, it can be preferentially ensured that the power device that has a high heat dissipation requirement can effectively dissipate heat, so that reliability of the heat dissipation system 100 is improved.

It should be noted herein that there may be specifically one or more first power sub-devices 501, and there may be specifically one or more second power sub-devices 502. A quantity of the first power sub-devices 501 and a quantity of the second power sub-devices 502 may be determined based on an actual design requirement. This is not specifically limited in this application.

The foregoing mainly describes structures and functions of the first liquid cooling assembly 20, the first power cavity 40, and the first power device 50. The following further describes in detail other structures included in the heat dissipation system 100 with reference to the foregoing content.

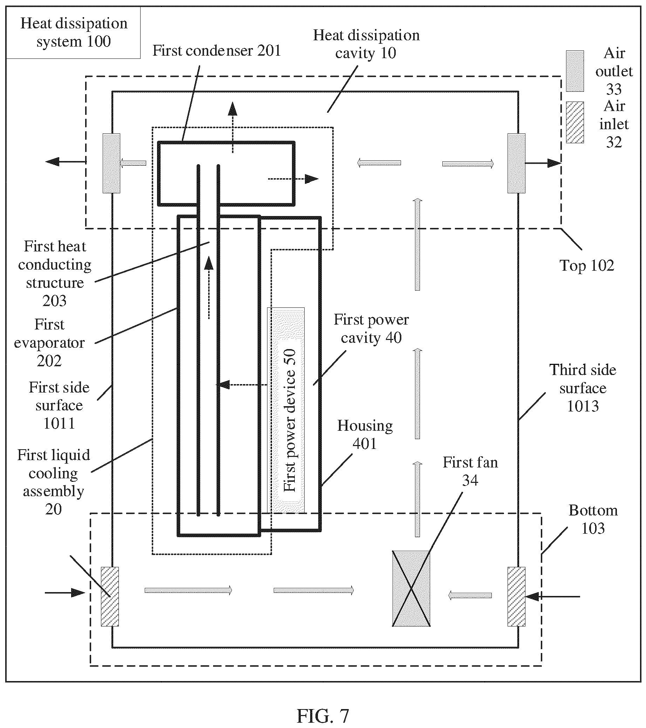

In some feasible implementations, FIG. 7 is a schematic diagram of another structure of a heat dissipation system according to an embodiment of this application. As shown in FIG. 7, the air cooling assembly 30 may further include a first fan 34. The air outlets 33 may be disposed at the top 102 of the heat dissipation cavity 10 (it should be understood that FIG. 7 shows an example in which there are two air outlets 32 that are respectively located on the first side surface 1011 and the third side surface 1013). The air inlets 32 and the first fan 34 may be disposed at the bottom 103 of the heat dissipation cavity 10 (it should be understood that FIG. 7 shows an example in which there are two air inlets 33 that are respectively located on the first side surface 1011 and the third side surface 1013). In addition, in the direction of the long side of the heat dissipation cavity 10, the air inlets 32 and the first fan 34 may be located below the first liquid cooling assembly 20 (in other words, the air inlets 32 and the first fan 34 may be located below the first power cavity 40 and the first evaporator 202).

In actual working, when the first power cavity 40 is located on a side that is of the first evaporator 202 and that faces the third side surface 1013, the air-cooled channel 31 passes through both the first power cavity 40 and the first condenser 201. The first fan 34 may blow air from the bottom 103 to the top 102, to bring, through the air-cooled channel 31, airflow that enters the air inlets 32 to the air outlets 33, and finally return the airflow to the outside of the heat dissipation cavity 10 through the air outlets 33. In this way, the airflow flowing in the air-cooled channel 31 may bring heat of the first power cavity 40 and the first condenser 201 to the outside of the heat dissipation cavity 10 for dissipation. Therefore, air-cooled heat dissipation for the first power device 50 is implemented. When the first power cavity 40 is located on a side that is of the first evaporator 202 and that faces the first side surface 1011, the air-cooled channel 31 passes through both the first evaporator 202 and the first condenser 201. The first fan 34 is still configured to: bring, through the air-cooled channel 31, airflow that enters the air inlets 32 to the air outlets 33, and return the airflow to the outside of the heat dissipation cavity 10 through the air outlets 33. In this way, the airflow flowing in the air-cooled channel 31 may bring heat of the first evaporator 202 and the first condenser 201 to the outside of the heat dissipation cavity 100 for dissipation. Therefore, air-cooled heat dissipation for the first power device 50 is implemented.

In the foregoing implementation, the air inlets 32 and the first fan 34 of the air cooling assembly 30 are disposed at the bottom 103, and the air outlets 33 are disposed at the top 102, so that the air-cooled channel 31 may pass through both the first condenser 201 and the first evaporator 202 or the first power cavity 40. Therefore, more efficient air-cooled heat dissipation for the first power device 50 may be implemented, and the heat dissipation efficiency of the heat dissipation system may be effectively improved. In addition, because there is a specific height difference between the air inlets 32 and the air outlets 33, dust removal can be performed on the airflow flowing in the air-cooled channel 31 by using the height difference. Therefore, dust entering the first condenser 201 is greatly reduced, the maintenance time of the first condenser 201 may be further prolonged, and the maintenance costs of the heat dissipation system 100 may be reduced.

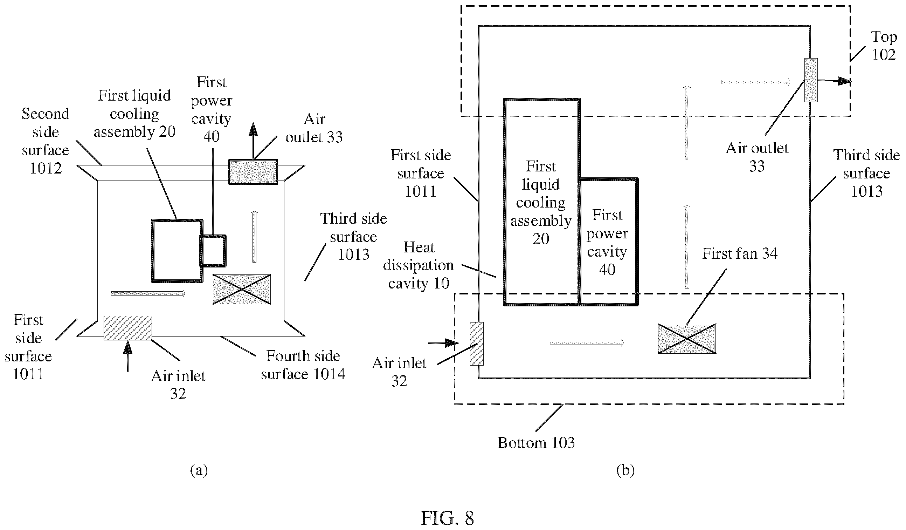

It should be noted that, FIG. 7 merely shows an example of quantities and specific locations of the air outlets 33 and the air inlets 32. In actual implementation, there may be one or more air inlets 32 and one or more air outlets 33. The air inlets 32 and the air outlets 33 may be alternatively disposed on side surfaces other than the first side surface 1011 (for example, on the second side surface 1012, the third side surface 1013, and the fourth side surface 1014 that are described above). For example, FIG. 8 is a schematic diagram of locations of an air inlet and an air outlet according to an embodiment of this application. Herein, (a) in FIG. 8 is a top view of the heat dissipation cavity 10, and (b) in FIG. 8 is a front view of the heat dissipation cavity 10. As shown in (a) in FIG. 8, in an optional implementation, there may be one air inlet 32 and one air outlet 33. The air inlet 32 may be disposed at the bottom 103 and located on the fourth side surface 1014. The air outlet 33 may be disposed at the top 102 and located on the second side surface 1012. Based on such a design, it can also be ensured that the air-cooled channel 31 can pass through the first liquid cooling assembly 20 and/or the first power cavity 40. Alternatively, as shown in (b) in FIG. 8, there may be one air inlet 32 and one air outlet 33. The air inlet is disposed at the bottom 103 and is located on the first side surface 1011. The air outlet 33 may be disposed at the top 102 and is located on the third side surface 1013. It may be understood that there is another possible case of locations and quantities of the air inlet 32 and the air outlet 33. This will not be enumerated in this application. These design solutions that can be associated based on the solutions provided in this application and that are of locations and quantities of the air inlet 32 and the air outlet 33 shall fall within the protection scope of this application. In conclusion, under a framework shown in FIG. 7, it only needs to be ensured that the air inlet 32 is disposed at the bottom 103, the air outlet 33 is disposed at the top 102, and that the air-cooled channel 31 can pass through the first liquid cooling assembly 20 and/or the first power cavity 40. This is not limited in this application.

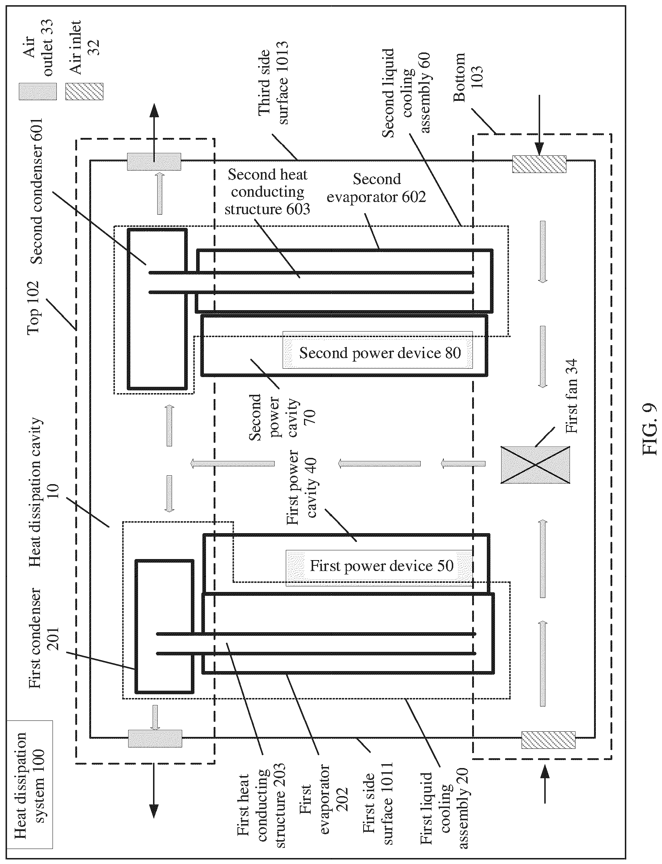

In an optional implementation, based on the air cooling assembly 30 described in FIG. 7, reference may be made to FIG. 9. FIG. 9 is a schematic diagram of another structure of a heat dissipation system according to an embodiment of this application. As shown in FIG. 9, the heat dissipation system 100 may further include a second liquid cooling assembly 60, a second power cavity 70, and a second power device 80. A structure of the second liquid cooling assembly 60 may be the same as the structure of the first liquid cooling assembly 20. The second liquid cooling assembly 60 may specifically include a second condenser 601, a second evaporator 602, and a second heat conducting structure 603. The second condenser 601 is connected to the second evaporator 602 through the second heat conducting structure 603. The second condenser 601 is disposed at the top 102 of the heat dissipation cavity 102, and is located on a side surface of the first condenser 201. The second power device 80 is disposed inside the second power cavity 70. The second power cavity 70 is in contact with the second evaporator 602. Moreover, both the second power cavity 70 and the second evaporator 602 are disposed below the second condenser 601. Herein, an internal structure of the second liquid cooling assembly 60 and a relative location relationship between the second liquid cooling assembly 60, the second power cavity 70, and the second power device 80 are respectively the same as the internal structure of the first liquid cooling assembly 20 and the relative location relationship between the first liquid cooling assembly 20, the first power cavity 40, and the first power device 50 described above. Reference may be made to the foregoing descriptions. Details are not described herein again.

It should be understood that, in the structure shown in FIG. 9, the second power cavity 70 is disposed on a side that is of the second evaporator 602 and that faces the first side surface 1011. In this case, the air-cooled channel 31 further passes through the second power cavity 70 and the second condenser 601. In another optional implementation, the second power cavity 70 may be alternatively disposed on a side that is of the second evaporator 602 and that faces the third side surface 1013. In this case, the air-cooled channel 31 passes through the second condenser 601 and the second evaporator 602, but does not pass through the second power cavity 70.

In actual working, both the second condenser 601 and the second evaporator 602 are also filled with a cooling working substance. A second circulation loop is formed between the second condenser 601 and the second evaporator 602 through the second heat conducting structure 603. The cooling working substance may circulate between the second condenser 601 and the second evaporator 602 through the second circulation loop, to bring heat of the second evaporator 602 to the second condenser 601 for dissipation. Therefore, liquid-cooled heat dissipation for the second power device 80 is implemented. For a specific working process of the second liquid cooling assembly 60 herein, reference may be made to the foregoing description of a working process of the first liquid cooling assembly 20. Details are not described herein again. Moreover, when the first fan 34 works normally, the first fan 34 may blow airflow that enters the air inlets 32 from the bottom 103 to the air outlets 33, so that the airflow flows in the air-cooled channel 31. When the air-cooled channel 31 further passes through the second power cavity 70 and the second condenser 601, the airflow flowing in the air-cooled channel 31 may be further used to bring heat of the second condenser 601 and the second power cavity 70 to the outside of the heat dissipation cavity 10 for dissipation. Therefore, air-cooled heat dissipation for the second power device 80 is implemented. When the air-cooled channel 31 further passes through the second evaporator 602 and the second condenser 601, the airflow flowing in the air-cooled channel 31 may be further used to bring heat of the second condenser 601 and the second evaporator 602 to the outside of the heat dissipation cavity 10 for dissipation. Therefore, air-cooled heat dissipation for the second power device 80 is implemented.

In the foregoing implementation, the second liquid cooling assembly 60 that has a same structure as the first liquid cooling assembly 20 is further disposed inside the heat dissipation cavity 10. In addition, the second evaporator 602 of the second liquid cooling assembly 60 is further in contact with the second power cavity 70 in which the second power device 80 is disposed. In this way, the heat dissipation system 100 can dissipate heat for both the first power device 50 and the second power device 80 through the first liquid cooling assembly 20, the air cooling assembly 30, and the second liquid cooling assembly 60, so that a load capability of the heat dissipation system 100 is greater, and a heat dissipation capability and the applicability of the heat dissipation system 100 may be improved.

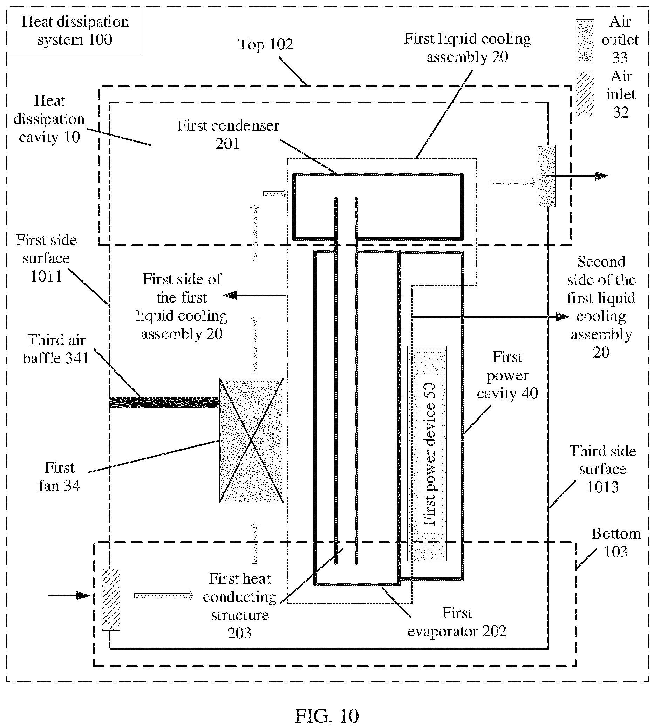

In some feasible implementations, FIG. 10 is a schematic diagram of another structure of a heat dissipation system according to an embodiment of this application. As shown in FIG. 10, the air cooling assembly 30 may further include a first fan 34. The air inlet 32 may be disposed at the bottom 103 of the heat dissipation cavity 10, and is located on a first side of the first liquid cooling assembly 20 (that is, a side that is of the first liquid cooling assembly 20 and that faces the first side surface 1011). The air outlet 33 is disposed at the top 102 of the heat dissipation cavity 10, and is located on a second side that is of the first liquid cooling assembly 20 and that is opposite to the first side (that is, a side that is of the first liquid cooling assembly 20 and that faces the third side surface 1013). It should be understood that FIG. 10 shows an example in which there is one air inlet 32 and one air outlet 33, and the air inlet 32 and the air outlet 33 are respectively disposed on the first side surface 1011 and the third side surface 1013.

It should be noted that, when the first evaporator 202 in the first liquid cooling assembly 20 is disposed in a manner that the first evaporator 202 faces away from the first power cavity 40 and faces the first side surface 1011 (it should be understood that FIG. 10 is an example of this scenario), the first fan 34 may be disposed on a side that is of the first evaporator 202 and that faces the air inlet 32 (which may be alternatively understood as a side that is of the first evaporator 202 and that faces the first side surface 1011). In this case, the air-cooled channel 31 passes through the first condenser 201 and the first evaporator 202. When the first evaporator 202 is disposed in a manner that the first evaporator 202 faces away from the first power cavity 40 and faces the third side surface 1013, the first fan 34 may be disposed on a side that is of the first power cavity 40 and that faces the air inlet 32 (which may be alternatively understood as a side that is of the first power cavity 40 and that faces the first side surface 1011). In this case, the air-cooled channel 31 passes through the first condenser 201 and the first power cavity 40.

In actual working, when the air-cooled channel 31 passes through both the first power cavity 40 and the first condenser 201, the first fan 34 may blow air from the bottom 103 to the top 102, to bring, through the air-cooled channel 31, airflow that enters the air inlet 32 to the air outlet 33, and blows the airflow to the outside of the heat dissipation cavity 10 through the air outlet 33. In this way, the airflow flowing in the air-cooled channel 31 may bring heat of the first power cavity 40 and the first condenser 201 to the outside of the heat dissipation cavity 100 for dissipation. Therefore, air-cooled heat dissipation for the first power device 50 is implemented. When the air-cooled channel 31 passes through both the first evaporator 202 and the first condenser 201, the first fan 34 may blow air from the bottom 103 to the top 102, to bring, through the air-cooled channel 31, airflow that enters the air inlet 32 to the air outlet 33, and blows the airflow to the outside of the heat dissipation cavity 10 through the air outlet 33. In this way, the airflow flowing in the air-cooled channel 31 may bring heat of the first evaporator 202 and the first condenser 201 to the outside of the heat dissipation cavity 100 for dissipation. Therefore, air-cooled heat dissipation for the first power device 50 is implemented.

It should be noted herein that, FIG. 10 merely shows an example of quantities and specific locations of the air outlet 33 and the air inlet 32. In actual implementation, there may be one or more air inlets 32. The one or more air inlets 32 may be disposed on one or more of the first side surface 1011, the second side surface 1012, the third side surface 1013, and the fourth side surface 1014. There may also be one or more air outlets 33. The one or more air outlets 33 may also be disposed on one or more of the first side surface 1011, the second side surface 1012, the third side surface 1013, and the fourth side surface 1014. In short, in actual implementation, it only needs to be ensured that the air inlet 32 is disposed at the bottom 103 and located on the first side of the first liquid cooling assembly 20, the air outlet 33 is disposed at the top 102 and located on the second side of the first liquid cooling assembly 20, and that the air-cooled channel 31 can pass through the first liquid cooling assembly 20 and/or the first power cavity 40. This is not specifically limited in this application.

In the foregoing implementation, the air inlet 32 is disposed at the bottom 103 and is located on the first side of the first liquid cooling assembly 20. The air outlet 33 is disposed at the top 102 and is located on the second side that is of the first liquid cooling assembly 20 and that is opposite to the first side. The first fan 34 is disposed on a side that is of the first evaporator 202 or the first power cavity 40 and that faces the air inlet 32. In this way, the air-cooled channel 31 can pass through both the first liquid cooling assembly 20 and/or the first power cavity 40, so that efficient heat dissipation for the first power device 50 may be implemented. In addition, because there is a specific height difference between the air inlet 32 and the air outlet 33, dust removal can be performed on the airflow flowing in the air-cooled channel 31 by using the height difference. Therefore, dust entering the first condenser 201 is greatly reduced, the maintenance time of the first condenser 201 may be further prolonged, and the maintenance costs of the heat dissipation system 100 may be reduced. Moreover, the first fan 34 is disposed on the side that is of the first evaporator 202 or the first power cavity 40 and that faces the air inlet 32, so that the height of the heat dissipation cavity 10 may be further reduced, and the applicability of the heat dissipation system 100 may be improved.

Optionally, still refer to FIG. 10. As shown in FIG. 10, an air baffle 341 (referred to as a third air baffle 341 in the following descriptions for ease of distinction) is further disposed between the first fan 34 and the first side surface 1011. One end of the third air baffle 341 is in contact with the first side surface 1011, and the other end is in contact with a side of the first fan 34. The third air baffle 341 is mainly configured to prevent airflow blown out by the first fan 34 from flowing back to an air inlet of the first fan 34, to ensure that the airflow in the air-cooled channel 31 can quickly flow from the air inlet 32 to the air outlet 33.

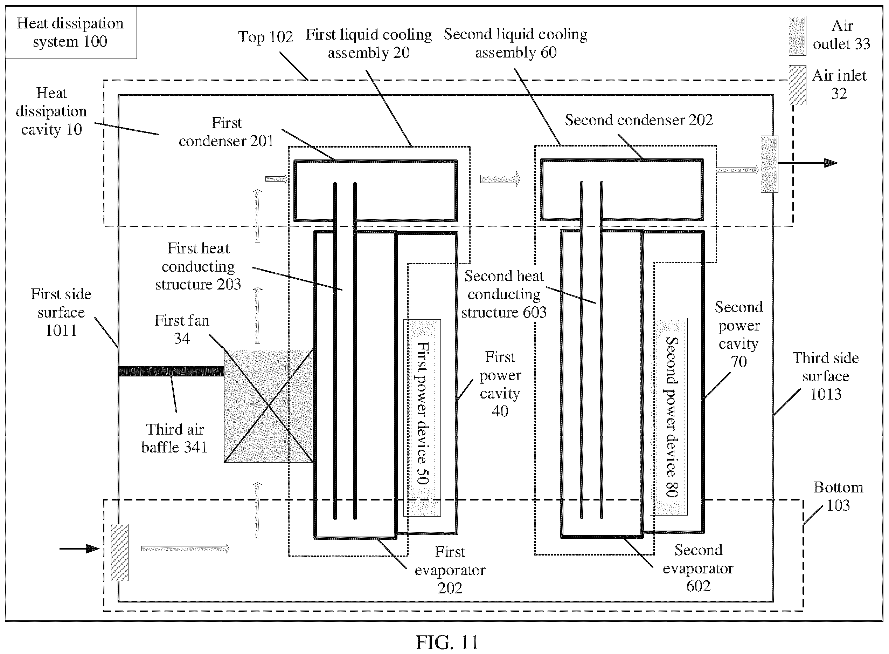

Optionally, with reference to the structure of the air cooling assembly 30 shown in FIG. 10, FIG. 11 is a schematic diagram of another structure of a heat dissipation system according to an embodiment of this application. As shown in FIG. 11, the heat dissipation system 100 may further include a second liquid cooling assembly 60, a second power cavity 70, and a second power device 80. A structure of the second liquid cooling assembly 60 may be the same as the structure of the first liquid cooling assembly 20. The second liquid cooling assembly 60 may specifically include a second condenser 601, a second evaporator 602, and a second heat conducting structure 603. The second condenser 601 is connected to the second evaporator 602 through the second heat conducting structure 603. The second condenser 601 is disposed at the top 102 of the heat dissipation cavity 102, and is located on a side that is of the first condenser 201 and that faces the air outlet 33 (in other words, the second condenser 601 is located on a side that is of the first condenser 201 and that faces the third side surface 1013). The second power device 80 is disposed inside the second power cavity 70. The second power cavity 70 is in contact with the second evaporator 602. Moreover, both the second power cavity 70 and the second evaporator 602 are disposed below the second condenser 601. Herein, an internal structure of the second liquid cooling assembly 60 and a relative location relationship between the second liquid cooling assembly 60, the second power cavity 70, and the second power device 80 are respectively the same as the internal structure of the first liquid cooling assembly 20 and the relative location relationship between the first liquid cooling assembly 20, the first power cavity 40, and the first power device 50 described above. Reference may be made to the foregoing descriptions. Details are not described herein again.

In actual working, the second liquid cooling assembly 60 may be configured to perform liquid-cooled heat dissipation on the second power device 80. For a specific working process of the second liquid cooling assembly 60, reference may be made to the foregoing description of a working process of the first liquid cooling assembly 20. Details are not described herein again. Moreover, when the first fan 34 works normally, the first fan 34 may blow airflow that enters the air inlet 32 from the bottom 103 to the air outlet 33, so that the airflow flows in the air-cooled channel 31. The airflow flowing in the air-cooled channel 31 may be further used to bring heat of the second condenser 601 to the outside of the heat dissipation cavity 10 for dissipation. Therefore, air-cooled heat dissipation for the second power device 80 is implemented.

In the foregoing implementation, the second liquid cooling assembly 60 that has a same structure as the first liquid cooling assembly 20 is further disposed inside the heat dissipation cavity 10. In addition, the second evaporator 602 of the second liquid cooling assembly 60 is further in contact with the second power cavity 70 in which the second power device 80 is disposed. In this way, the heat dissipation system 100 can dissipate heat for both the first power device 50 and the second power device 80 through the first liquid cooling assembly 20, the air cooling assembly 30, and the second liquid cooling assembly 60, so that a load capability of the heat dissipation system 100 is greater, and a heat dissipation capability and the applicability of the heat dissipation system 100 may be improved.

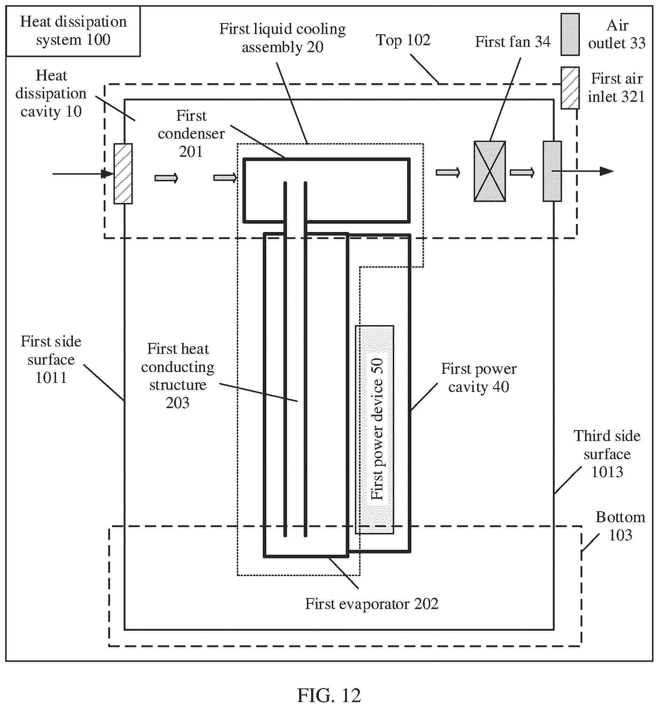

In some feasible implementations, FIG. 12 is a schematic diagram of another structure of a heat dissipation system according to an embodiment of this application. As shown in FIG. 12, the air cooling assembly 30 may include a first fan 34. The air inlet 32 of the air cooling assembly 30 may include a first air inlet 321. The first air inlet 321, the air outlet 33, and the first fan 34 may all be disposed at the top 102 of the heat dissipation cavity 10. In addition, the first air inlet 321 is disposed on a first side of the first condenser 201 (which may be alternatively understood as a side that is of the first condenser 201 and that faces the first side surface 1011). The first fan 34 is disposed on a second side that is of the first condenser 201 and that is opposite to the first side (which may be alternatively understood as a side that is of the first condenser 201 and that faces the third side surface 1013). The air outlet 33 is disposed on a side that is of the first fan 34 and that faces away from the first condenser 201 (which may be alternatively understood as a side that is of the first fan 34 and that faces the third side surface 1013). It should be understood that FIG. 12 shows an example in which there is one first air inlet 321 and one air outlet 33, the first air inlet 321 is disposed on the first side surface 1011, and the air outlet 33 is disposed on the third side surface 1013.

In actual working, the first fan 34 may blow air to a location of the air outlet 33, to bring, through the air-cooled channel 31, airflow that enters the first air inlet 321 to the air outlet 33, and blows the airflow to the outside of the heat dissipation cavity 10 through the air outlet 33. In this way, the airflow flowing in the air-cooled channel 31 may bring heat of the first condenser 201 to the outside of the heat dissipation cavity 100 for dissipation. Therefore, air-cooled heat dissipation for the first power device 50 is implemented.

In the foregoing implementation, the first air inlet 321, the air outlet 33, and the first fan 34 may all be disposed at the top 102 of the heat dissipation cavity 10, so that the air-cooled channel 31 can pass through the first condenser 201. Therefore, air-cooled heat dissipation for the first power device 50 may be implemented. In addition, the first fan 34 is disposed on one side of the first condenser 201, so that the height of the heat dissipation cavity 10 may be reduced, and the applicability of the heat dissipation system may be improved.

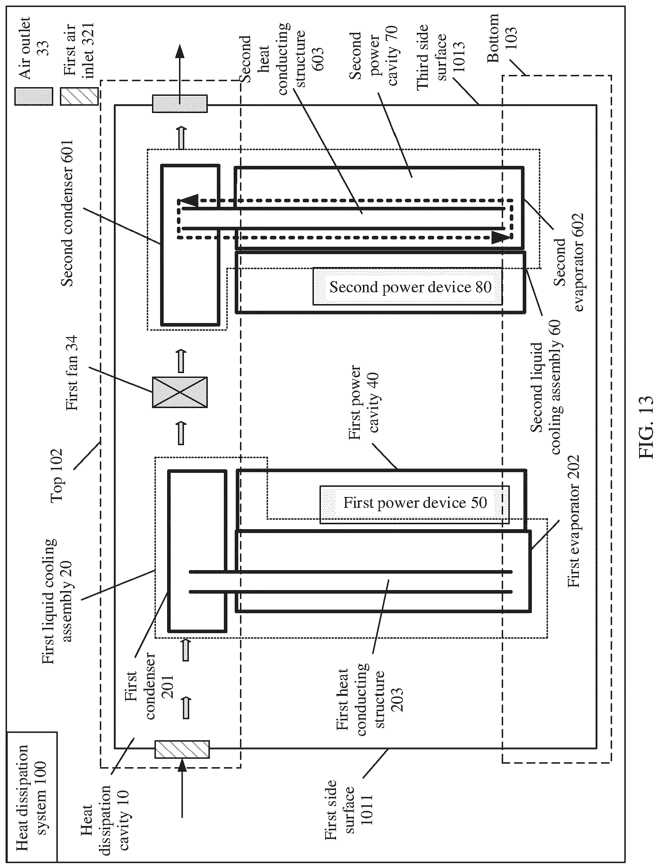

In an optional implementation, with reference to the structure of the air cooling assembly 30 shown in FIG. 12, further refer to FIG. 13. FIG. 13 is a schematic diagram of another structure of a heat dissipation system according to an embodiment of this application. As shown in FIG. 13, the heat dissipation system 100 may further include a second liquid cooling assembly 60, a second power cavity 70, and a second power device 80. A structure of the second liquid cooling assembly 60 may be the same as the structure of the first liquid cooling assembly 20. The second liquid cooling assembly 60 may specifically include a second condenser 601, a second evaporator 602, and a second heat conducting structure 603. The second condenser 601 is connected to the second evaporator 602 through the second heat conducting structure 603. The second condenser 601 is disposed at the top 102 of the heat dissipation cavity 102, and is located on a side that is of the first condenser 201 and that faces the air outlet 33 (in other words, the second condenser 601 is located on a side that is of the first condenser 201 and that faces the third side surface 1013). The second power device 80 is disposed inside the second power cavity 70. The second power cavity 70 is in contact with the second evaporator 602. Moreover, both the second power cavity 70 and the second evaporator 602 are disposed below the second condenser 601. Herein, the internal structure of the first liquid cooling assembly 20 and the relative location relationship among the first liquid cooling assembly 20, the first power cavity 40, and the first power device 50 are respectively the same as the internal structure of the first liquid cooling assembly 20 and the relative location relationship among the first liquid cooling assembly 20, the first power cavity 40, and the first power device 50 described above. Reference may be made to the foregoing descriptions. Details are not described herein again.

In actual working, the second liquid cooling assembly 60 may be configured to perform liquid-cooled heat dissipation on the second power device 80. For a specific working process of the second liquid cooling assembly 60, reference may be made to the foregoing description of a working process of the first liquid cooling assembly 20. Details are not described herein again. Moreover, when the first fan 34 works normally, airflow blown by the first fan 34 further directly passes through the second condenser 601, to bring, through the air flow, heat of the second condenser 601 to the outside of the heat dissipation cavity 10 for dissipation. Therefore, air-cooled heat dissipation for the second power device 80 is implemented.

In the foregoing implementation, the second liquid cooling assembly 60 that has a same structure as the first liquid cooling assembly 20 is further disposed inside the heat dissipation cavity 10. In this way, the heat dissipation system 100 can dissipate heat for both the first power device 50 and the second power device 80 through the first liquid cooling assembly 20, the air cooling assembly 30, and the second liquid cooling assembly 60, so that a load capability of the heat dissipation system 100 is greater, and a heat dissipation capability of the heat dissipation system 100 may be improved. In addition, the first fan 34 is further disposed between the first condenser 201 and the second condenser 601, so that the height of the heat dissipation system 100 may be reduced, and the applicability of the heat dissipation system 100 may be improved.

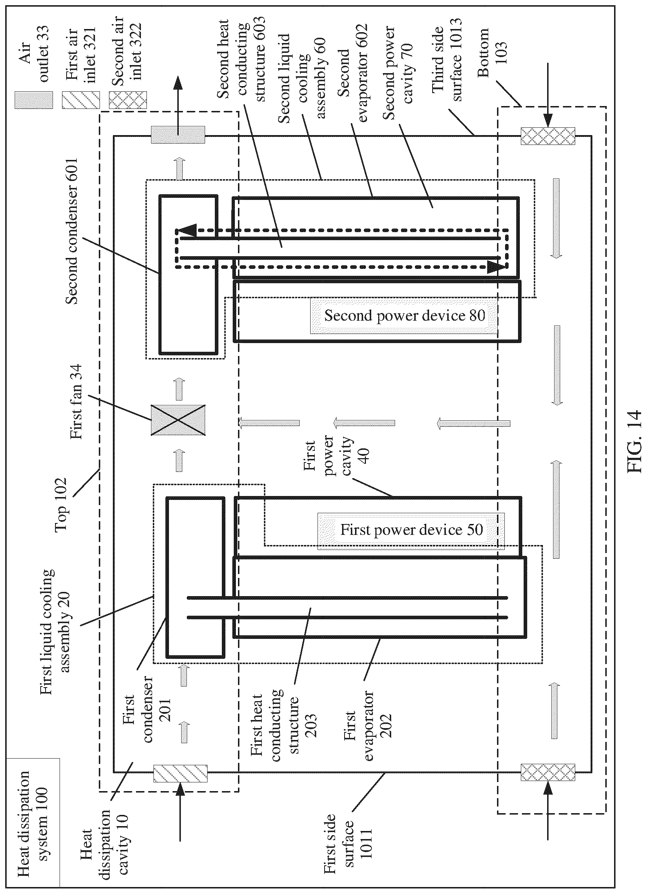

Further, in another optional implementation, FIG. 14 is a schematic diagram of another structure of a heat dissipation system according to an embodiment of this application. As shown in FIG. 14, the air inlets 32 may further include second air inlets 322. The second air inlets 322 may be disposed at the bottom 103. It should be understood that FIG. 14 shows an example in which there are two second air inlets 322 that are respectively disposed on the first side surface 1011 and the second side surface 1012. Airflow outside the heat dissipation cavity 10 can enter the heat dissipation cavity 10 through the second air inlets 322, flows to the air outlet 33 through the air-cooled channel 31 under an action of the first fan 34, and finally returns to the outside of the heat dissipation cavity 10 through the air outlet 33.

In actual working, when the first evaporator 202 faces away from the first power cavity 40 and faces the first side surface 1011, and the second evaporator 602 faces away from the second power cavity 70 and faces the third side surface 1013, the air-cooled channel 31 further passes through the first power cavity 40 and the second power cavity 70. Under the action of the first fan 34, the airflow that enters the second air inlets 322 is blown through the first power cavity 40 and the second power cavity 70, to bring the first power cavity 40 and the second power cavity 70 to the outside of the heat dissipation cavity for dissipation. Therefore, the air cooling assembly 30 can more effectively implement air-cooled heat dissipation for the first power device 50 and the second power device 80.

When the first evaporator 202 faces away from the first power cavity 40 and faces the first side surface 1011, and the second power cavity 70 faces away from the second evaporator 602 and faces the third side surface 1013, the air-cooled channel 31 further passes through the first power cavity 40 and the second evaporator 602. Under the action of the first fan 34, the airflow that enters the second air inlets 322 is blown through the first power cavity 40 and the second evaporator 602, to bring the first power cavity 40 and the second evaporator 602 to the outside of the heat dissipation cavity for dissipation. Therefore, the air cooling assembly 30 can more effectively implement air-cooled heat dissipation for the first power device 50 and the second power device 80.

When the first power cavity 40 faces away from the first evaporator 202 and faces the first side surface 1011, and the second power cavity 70 faces away from the second evaporator 602 and faces the third side surface 1013, the air-cooled channel 31 further passes through the first evaporator 202 and the second evaporator 602. Under the action of the first fan 34, the airflow that enters the second air inlets 322 is blown through the first evaporator 202 and the second evaporator 602, to bring the first evaporator 202 and the second evaporator 602 to the outside of the heat dissipation cavity for dissipation. Therefore, the air cooling assembly 30 can more effectively implement air-cooled heat dissipation for the first power device 50 and the second power device 80.

When the first power cavity 40 faces away from the first evaporator 202 and faces the first side surface 1011, and the second evaporator 602 faces away from the second power cavity 70 and faces the third side surface 1013, the air-cooled channel 31 further passes through the first evaporator 202 and the second power cavity 70. Under the action of the first fan 34, the airflow that enters the second air inlets 322 is blown through the first evaporator 202 and the second power cavity 70, to bring the first evaporator 202 and the second power cavity 70 to the outside of the heat dissipation cavity for dissipation. Therefore, the air cooling assembly 30 can more effectively implement air-cooled heat dissipation for the first power device 50 and the second power device 80.

It should be noted herein that FIG. 14 merely shows an example of a quantity and specific locations of the second air inlets 322. In actual implementation, there may be one or more second air inlets 322. The one or more second air inlets 322 may be disposed on one or more of the first side surface 1011, the second side surface 1012, the third side surface 1013, and the fourth side surface 1014. In short, in actual implementation, it only needs to be ensured that the second air inlets 322 are disposed at the bottom 103, and that the air-cooled channel 31 can further pass through any two of the first condenser 201, the second condenser 601, the first power cavity 40, and the second power cavity 70. This is not specifically limited in this application.

In the foregoing implementation, after the second air inlets 322 are additionally disposed at the bottom 103, the air-cooled channel 31 passes through the first condenser 201 and the second condenser 601, and further passes through any two of the first evaporator 202, the second evaporator 602, the first power cavity 40, and the second power cavity 70. In this way, the air cooling assembly 30 can not only perform air-cooled heat dissipation on the first condenser 201 and the second condenser 601, but also perform air-cooled heat dissipation on any two of the first evaporator 202, the second evaporator 602, the first power cavity 40, and the second power cavity 70, thereby effectively improving heat dissipation efficiency of the heat dissipation system 100.

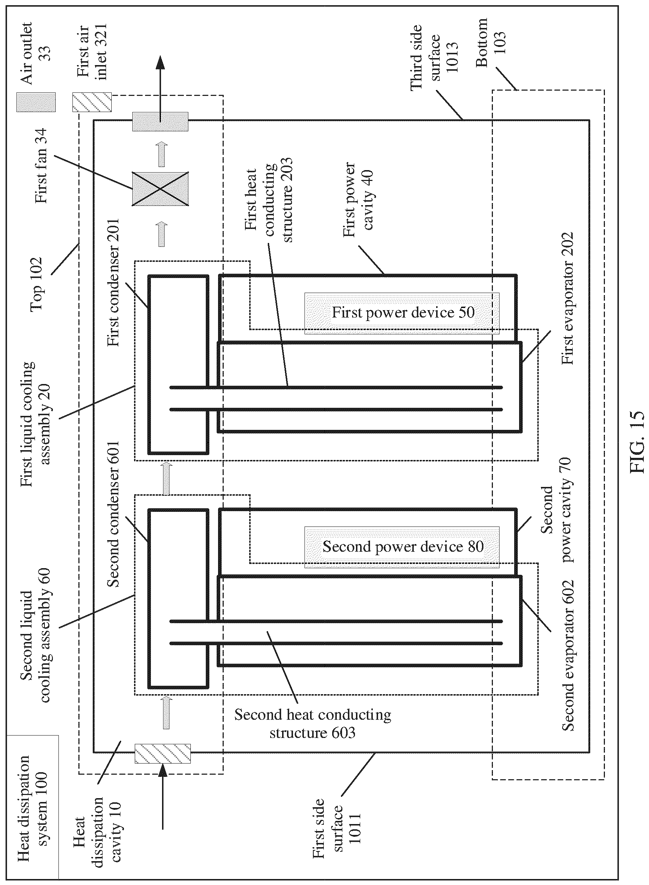

In still another optional implementation, with reference to the structure of the air cooling assembly 30 shown in FIG. 12, further refer to FIG. 15. FIG. 15 is a schematic diagram of another structure of a heat dissipation system according to an embodiment of this application. As shown in FIG. 15, the heat dissipation system 100 may further include a second liquid cooling assembly 60, a second power cavity 70, and a second power device 80. A structure of the second liquid cooling assembly 60 may be the same as the structure of the first liquid cooling assembly 20. The second liquid cooling assembly 60 may specifically include a second condenser 601, a second evaporator 602, and a second heat conducting structure 603. The second condenser 601 is connected to the second evaporator 602 through the second heat conducting structure 603. The second condenser 601 is disposed at the top 102 of the heat dissipation cavity 10, and is located on a side that is of the first condenser 201 and that faces away from the air outlet 33 (in other words, the second condenser 601 is located on a side that is of the first condenser 201 and that faces the first side surface 1011). In this way, the air-cooled channel 31 further passes through the second condenser 601. The second power device 80 is disposed inside the second power cavity 70. The second power cavity 70 is in contact with the second evaporator 602. Moreover, both the second power cavity 70 and the second evaporator 602 are disposed below the second condenser 601. Herein, an internal structure of the second liquid cooling assembly 60 and a relative location relationship between the second liquid cooling assembly 60, the second power cavity 70, and the second power device 80 are respectively the same as the internal structure of the first liquid cooling assembly 20 and the relative location relationship between the first liquid cooling assembly 20, the first power cavity 40, and the first power device 50 described above. Reference may be made to the foregoing descriptions. Details are not described herein again.

In actual working, the second liquid cooling assembly 60 may be configured to perform liquid-cooled heat dissipation on the second power device 80. For a specific working process of the second liquid cooling assembly 60, reference may be made to the foregoing description of a working process of the first liquid cooling assembly 20. Details are not described herein again. Moreover, when the first fan 34 works normally, airflow that enters the first air inlet 321 passes through the second condenser 601, to bring, through the airflow, heat of the second condenser 601 to the outside of the heat dissipation cavity 10 for dissipation. Therefore, air-cooled heat dissipation for the second power device 80 is implemented.

In the foregoing implementation, the second liquid cooling assembly 60 that has a same structure as the first liquid cooling assembly 20 is further disposed inside the heat dissipation cavity 10. In this way, the heat dissipation system 100 can dissipate heat for both the first power device 50 and the second power device 80 through the first liquid cooling assembly 20, the air cooling assembly 30, and the second liquid cooling assembly 60, so that a load capability of the heat dissipation system 100 is greater, and a heat dissipation capability of the heat dissipation system 100 may be improved. In addition, the first fan 34 is further disposed on a side that is of the first condenser 201 and that faces away from the second condenser 601, so that the height of the heat dissipation system 100 is reduced, subsequent maintenance of the first fan 34 is also facilitated, and the applicability of the heat dissipation system 100 may be improved.

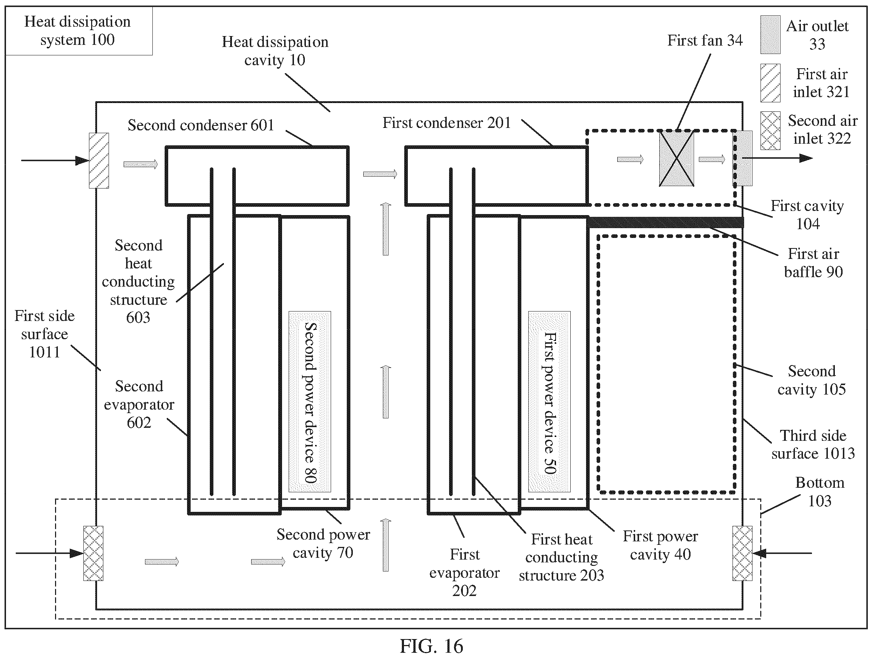

Optionally, FIG. 16 is a schematic diagram of another structure of a heat dissipation system according to an embodiment of this application. As shown in FIG. 16, a first air baffle 90 is further disposed between a first cavity 104 and a second cavity 105 of the heat dissipation cavity 10. The first cavity 104 is a cavity that is included in the heat dissipation cavity 10 and that is located on a side that is of the first condenser 201 and that faces the air outlet 33 (in other words, the first cavity 104 is a cavity between the first condenser 201 and the third side surface 1013). When the first power cavity 40 faces away from the first evaporator 202 and faces the third side surface 1013, the second cavity is a cavity that is included in the heat dissipation cavity 10 and that is located on a side that is of the first power cavity 40 and that faces away from the second liquid cooling assembly 60 (in other words, the second cavity 105 is a cavity between the first power cavity 40 and the third side surface 1013). When the first evaporator 202 faces away from the first power cavity 40 and faces the third side surface 1013, the second cavity is a cavity that is included in the heat dissipation cavity 10 and that is located on a side that is of the first evaporator 202 and that faces away from the second liquid cooling assembly 60 (in other words, the second cavity 105 is a cavity between the first evaporator 202 and the third side surface 1013).

In actual working, the first air baffle 90 is mainly configured to block ventilation between the first cavity 104 and the second cavity 105. The first air baffle 90 can prevent the first fan 34 from blowing air in the second cavity 105 to the air outlet 33, to ensure that most of the airflow in the air-cooled channel 31 flows through the first condenser 201 and the second condenser 601. In this way, heat dissipation efficiency of the air cooling assembly 30 for the first condenser 201 and the second condenser 601 can be ensured.

Optionally, still refer to FIG. 16. As shown in FIG. 16, the air inlets 32 may further include second air inlets 322. The second air inlets 322 may be disposed at the bottom 103. It should be understood that FIG. 16 shows an example in which there are two second air inlets 322 that are respectively disposed on the first side surface 1011 and the third side surface 1013. Airflow outside the heat dissipation cavity 10 can enter the heat dissipation cavity 10 through the second air inlets 322, flows to the air outlet 33 through the air-cooled channel 31 under an action of the first fan 34, and finally returns to the outside of the heat dissipation cavity 10 through the air outlet 33.

In actual working, when the air-cooled channel 31 further passes through the first power cavity 40 and the second power cavity 70, under the action of the first fan 34, the airflow that enters the second air inlets 322 is blown through the first power cavity 40 and the second power cavity 70, to bring the first power cavity 40 and the second power cavity 70 to the outside of the heat dissipation cavity for dissipation. Therefore, air-cooled heat dissipation for the first power device 50 and the second power device 80 is implemented.

When the air-cooled channel 31 further passes through the first power cavity 40 and the second evaporator 602, under the action of the first fan 34, the airflow that enters the second air inlets 322 is blown through the first power cavity 40 and the second evaporator 602, to bring the first power cavity 40 and the second evaporator 602 to the outside of the heat dissipation cavity for dissipation. Therefore, air-cooled heat dissipation for the first power device 50 and the second power device 80 is implemented.

When the air-cooled channel 31 further passes through the first evaporator 202 and the second evaporator 602, under the action of the first fan 34, the airflow that enters the second air inlets 322 is blown through the first evaporator 202 and the second evaporator 602, to bring the first evaporator 202 and the second evaporator 602 to the outside of the heat dissipation cavity for dissipation. Therefore, air-cooled heat dissipation for the first power device 50 and the second power device 80 is implemented.

When the air-cooled channel 31 further passes through the first evaporator 202 and the second power cavity 70, under the action of the first fan 34, the airflow that enters the second air inlets 322 is blown through the first evaporator 202 and the second power cavity 70, to bring the first evaporator 202 and the second power cavity 70 to the outside of the heat dissipation cavity. Therefore, air-cooled heat dissipation for the first power device 50 and the second power device 80 is implemented.

It should be understood that FIG. 16 merely shows an example of a quantity and specific locations of the second air inlets 322. In actual implementation, there may be one or more second air inlets 322. The second air inlets 322 may also be disposed on one or more of the first side surface 1011, the second side surface 1012, the third side surface 1013, or the fourth side surface 1014. In short, it only needs to be ensured that the second air inlets 322 are disposed at the bottom 103, and that the air-cooled channel 31 can further pass through any two of the first evaporator 202, the second evaporator 602, the first power cavity 40, and the second power cavity 70. This is not specifically limited in this application.

In the foregoing implementation, after the second air inlets 322 are additionally disposed at the bottom 103, the air-cooled channel 31 passes through the first condenser 201 and the second condenser 601, and further passes through any two of the first evaporator 202, the second evaporator 602, the first power cavity 40, and the second power cavity 70. In this way, the air cooling assembly 30 can not only perform air-cooled heat dissipation on the first condenser 201 and the second condenser 601, but also perform heat dissipation on any two of the first evaporator 202, the second evaporator 602, the first power cavity 40, and the second power cavity 70, thereby effectively improving heat dissipation efficiency of the heat dissipation system 100.

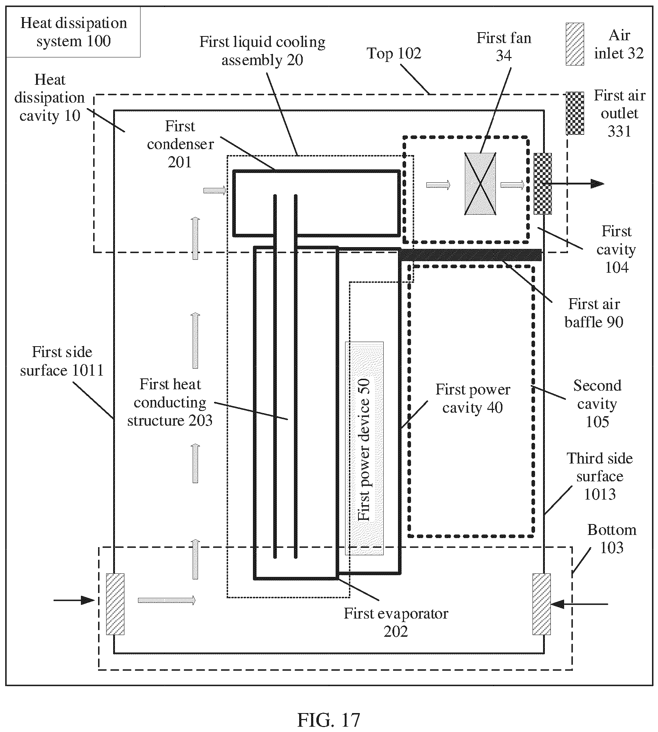

In some feasible implementations, FIG. 17 is a schematic diagram of another structure of a heat dissipation system according to an embodiment of this application. As shown in FIG. 17, the air cooling assembly 30 further includes a first fan 34. The air outlet 32 of the air cooling assembly 30 may include a first air outlet 331. The air inlet 32 is disposed at the bottom 103 of the heat dissipation cavity 10 (it is assumed in FIG. 17 that there is only one air inlet 32 and that the air inlet 32 is disposed on the first side surface 1011). The first air outlet 331 is disposed at the top 102 of the heat dissipation cavity 10 (it is assumed in FIG. 17 that there is only one first air outlet 331 and that the first air outlet 331 is disposed on the third side surface 1013). The first fan 34 is disposed on a side that is of the first condenser 201 and that faces the first air outlet 331. A first air baffle 90 is further disposed between a first cavity 104 and a second cavity 105 of the heat dissipation cavity 10. The first cavity 104 is a cavity that is included in the heat dissipation cavity 10 and that is located on a side that is of the first condenser 201 and that faces the air outlet 33 (in other words, the first cavity 104 is a cavity between the first condenser 201 and the third side surface 1013). When the first power cavity 40 faces away from the first evaporator 202 and faces the third side surface 1013, the second cavity is a cavity that is included in the heat dissipation cavity 10 and that is located on a side that is of the first power cavity 40 and that faces away from the second liquid cooling assembly 60 (in other words, the second cavity 105 is a cavity between the first power cavity 40 and the third side surface 1013). When the first evaporator 202 faces away from the first power cavity 40 and faces the third side surface 1013, the second cavity is a cavity that is included in the heat dissipation cavity 10 and that is located on a side that is of the first evaporator 202 and that faces away from the second liquid cooling assembly 60 (in other words, the second cavity 105 is a cavity between the first evaporator 202 and the third side surface 1013). The first air baffle 90 is mainly configured to block ventilation between the first cavity 104 and the second cavity 105, to prevent the first fan 34 from blowing air in the second cavity 105 to the first air outlet 331, thereby ensuring that the airflow in the air-cooled channel 31 can be in full contact with the first liquid cooling assembly 20 and/or the first power cavity 40. In this way, heat dissipation efficiency of the air cooling assembly 30 can be ensured.

In actual working, the first fan 34 may blow air to the first air outlet 331, to bring, through the air-cooled channel 31, airflow that enters the air inlet 32 to the first air outlet 331, and blows the airflow to the outside of the heat dissipation cavity 10 through the first air outlet 331. When the first power cavity 40 faces away from the first evaporator 202 and faces the third side surface 1013 (that is, a structure shown in FIG. 17), the air-cooled channel 31 passes through the first condenser 201 and the first evaporator 202, and the airflow in the air-cooled channel 31 may bring heat of the first condenser 201 and the first evaporator 202 to the outside of the heat dissipation cavity 10 for dissipation. Therefore, air-cooled heat dissipation for the first power device 50 is implemented. When the first evaporator 202 faces away from the first power cavity 40 and faces the third side surface 1013, the air-cooled channel 31 passes through the first condenser 201 and the first power cavity 40, and the airflow in the air-cooled channel 31 may bring heat of the first condenser 201 and the first power cavity 40 to the outside of the heat dissipation cavity 10 for dissipation. Therefore, air-cooled heat dissipation for the first power device 50 is implemented.

In the foregoing implementation, the air inlet 32 is disposed at the bottom 103. The first air outlet 33 is disposed at the top 102. The first fan 34 is disposed on the side that is of the first condenser 201 and that faces the first air outlet 331. In this way, the air-cooled channel 31 can pass through the first liquid cooling assembly 20 and/or the first power cavity 40, so that efficient heat dissipation for the first power device 50 may be implemented. In addition, because there is a specific height difference between the air inlet 32 and the first air outlet 331, dust removal can be performed on the airflow flowing in the air-cooled channel 31 by using the height difference. Therefore, dust entering the first condenser 201 is greatly reduced, the maintenance time of the first condenser 201 may be further prolonged, and the maintenance costs of the heat dissipation system 100 may be reduced. Moreover, the first fan 34 is disposed on a side surface of the first condenser 201, so that the height of the heat dissipation cavity 10 may be further reduced, and the applicability of the heat dissipation system 100 is improved.

It should be noted herein that FIG. 17 merely shows an example of quantities and specific locations of the air inlet 32 and the first air outlet 331. In actual implementation, there may be a plurality of air inlets 32. The air inlets 32 may be disposed on one or more of the first side surface 1011, the second side surface 1012, the third side surface 1013, and the fourth side surface 1014. There may also be one or more first air outlets 331. The one or more first air outlets 331 may also be disposed on one or more of the first side surface 1011, the second side surface 1012, the third side surface 1013, and the fourth side surface 1014. In short, in actual implementation, it only needs to be ensured that the first air outlet 331 is disposed at the top 102, the air inlet 32 is disposed at the top 102, and that the air-cooled channel 31 can pass through the first liquid cooling assembly 20 and/or the first power cavity 40. This is not specifically limited in this application.

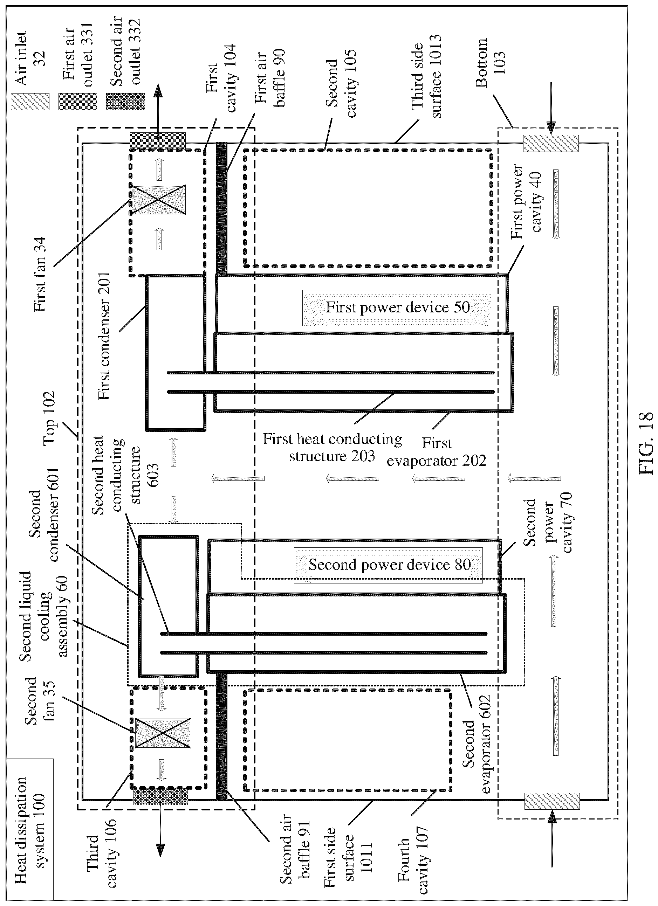

In an optional implementation, with reference to the structure of the air cooling assembly 30 shown in FIG. 17, further refer to FIG. 18. FIG. 18 is a schematic diagram of another structure of a heat dissipation system according to an embodiment of this application. As shown in FIG. 18, the heat dissipation system 100 may further include a second liquid cooling assembly 60, a second power cavity 70, and a second power device 80. A structure of the second liquid cooling assembly 60 may be the same as the structure of the first liquid cooling assembly 20. The air cooling assembly 30 further includes a second fan 35. The air outlet 33 further includes second air outlets 332. A second condenser 601 of the second liquid cooling assembly 60 is disposed on a side that is of the first condenser 201 and that faces away from the first fan 34 (which may be alternatively understood as a side that is of the first condenser 201 and that faces the first side surface 1011). The second power cavity 70 is in contact with a second evaporator 602 of the second liquid cooling assembly 60. In addition, the second power cavity 70 and the second evaporator 602 are disposed below the second condenser 601. The second power device 80 is disposed inside the second power cavity 70. The second fan 35 is located on a side that is of the second condenser 601 and that faces away from the first condenser 201. The second air outlets 332 are disposed at the top 102 of the heat dissipation cavity 10 (it should be understood that FIG. 18 shows an example in which there are two second air outlets 332 that are respectively disposed on the first side surface 1011 and the third side surface 1013). Herein, an internal structure of the second liquid cooling assembly 60 and a relative location relationship between the second liquid cooling assembly 60, the second power cavity 70, and the second power device 80 are respectively the same as the internal structure of the first liquid cooling assembly 20 and the relative location relationship between the first liquid cooling assembly 20, the first power cavity 40, and the first power device 50 described above. Reference may be made to the foregoing descriptions. Details are not described herein again.

Moreover, a second air baffle 91 is disposed between a third cavity 106 and a fourth cavity 107 of the heat dissipation cavity 10. The third cavity 106 is a cavity that is included in the heat dissipation cavity 10 and that is located on a side that is of the second condenser 601 and that faces the second air outlets 332 (in other words, the third cavity 106 is a cavity between the second condenser 601 and the first side surface 1011). When the second power cavity 70 faces away from the second evaporator 602 and faces the first side surface 1011, the fourth cavity 107 is a cavity that is included in the heat dissipation cavity 10 and that is located on a side that is of the second power cavity 70 and that faces away from the first liquid cooling assembly 20 (in other words, the fourth cavity 107 is a cavity between the second power cavity 70 and the first side surface 1011). When the second evaporator 602 faces away from the second power cavity 70 and faces the first side surface 1011, the fourth cavity 107 is a cavity that is included in the heat dissipation cavity 10 and that is located on a side that is of the second evaporator 602 and that faces away from the first liquid cooling assembly 20 (in other words, the fourth cavity 107 is a cavity between the second evaporator 602 and the first side surface 1011). The second air baffle 91 is mainly configured to block ventilation between the third cavity 106 and the fourth cavity 107, to prevent the second fan 35 from blowing air in the fourth cavity 107 to the second air outlets 332, thereby ensuring that the airflow in the air-cooled channel 31 can be in full contact with the second liquid cooling assembly 60 and/or the second power cavity 70. In this way, the heat dissipation efficiency of the air cooling assembly 30 can be further ensured.

In actual working, the second fan 35 may blow air to the second air outlets 332, to bring, through the air-cooled channel 31, airflow that enters the air inlets 32 to the second air outlets 332, and blows the airflow to the outside of the heat dissipation cavity 10 through the second air outlets 332. When the second power cavity 70 faces away from the second evaporator 602 and faces the first side surface 1011, the air-cooled channel 31 further passes through the second power cavity 70 and the second condenser 601, and the airflow in the air-cooled channel 31 may further bring heat of the second power cavity 70 and the second condenser 601 to the outside of the heat dissipation cavity 10 for dissipation. Therefore, air-cooled heat dissipation for the second power device 80 is implemented. When the second evaporator 602 faces away from the second power cavity 70 and faces the first side surface 1011, the air-cooled channel 31 further passes through the second condenser 601 and the second evaporator 602, and the airflow in the air-cooled channel 31 may further bring heat of the second condenser 601 and the second evaporator 602 to the outside of the heat dissipation cavity 10 for dissipation. Therefore, air-cooled heat dissipation for the second power device 80 is implemented.

It should be noted herein that FIG. 18 merely shows an example of a quantity and specific locations of the second air outlets 332. In actual implementation, there may be alternatively a plurality of second air outlets 332. The second air outlets 332 may be alternatively disposed on any one or more of the first side surface 1011, the second side surface 1012, and the fourth side surface 1014. In short, in actual implementation, it only needs to be ensured that the second air outlets 332 are disposed at the top 102, and that the air-cooled channel 31 can pass through any two of the first liquid cooling assembly 20, the first power cavity 40, the second liquid cooling assembly 60, and the second power cavity 70. This is not specifically limited in this application.

In the foregoing implementation, the second liquid cooling assembly 60 that has a same structure as the first liquid cooling assembly 20 is further disposed inside the heat dissipation cavity 10. In addition, the second fan 35 and the second air outlets 332 are additionally disposed. In this way, the heat dissipation system 100 can dissipate heat more effectively for the first power device 50 and the second power device 80 through the first liquid cooling assembly 20, the air cooling assembly 30, and the second liquid cooling assembly 60, so that a load capability of the heat dissipation system 100 is greater, and a heat dissipation capability of the heat dissipation system 100 is stronger. In addition, the first fan 34 and the second fan 35 are respectively disposed on outer sides of the condensers, so that the height of the heat dissipation system 100 is reduced, and subsequent maintenance of the fans is also facilitated.

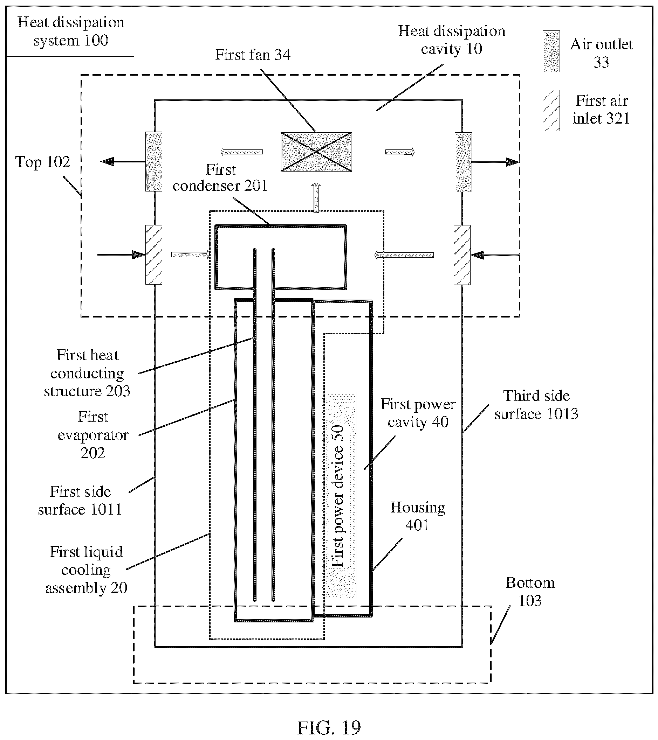

In some feasible implementations, FIG. 19 is a schematic diagram of another structure of a heat dissipation system according to an embodiment of this application. As shown in FIG. 19, the air cooling assembly 30 may further include a first fan 34, and the air inlet 32 may include first air inlets 321. The first fan 34 is disposed at the top 102, and is located above the first condenser 201. The first air inlets 321 are also disposed at the top 102, and are located on side surfaces of the first condenser 201. It should be understood that FIG. 19 shows an example in which there are two first air inlets 321 that are respectively disposed on surfaces that are of the first condenser 201 and that respectively face the first side surface 1011 and the third side surface 1013. The air outlets 33 are respectively disposed above the first air inlets 32, and are respectively located on side surfaces of the first fan 34. It should be understood that, FIG. 19 shows an example in which there are two air outlets 33 that are respectively disposed on surfaces that are of the first fan 34 and that respectively face the first side surface 1011 and the third side surface 1013.

In actual working, the first fan 34 may blow air to the air outlets 33, to bring, through the air-cooled channel 31, airflow that enters the first air inlets 321 to the air outlets 33, and blows the airflow to the outside of the heat dissipation cavity 10 through the air outlets 33. Because the air-cooled channel 31 passes through the first condenser 201, the airflow flowing in the air-cooled channel 31 may bring heat of the first condenser 201 to the outside of the heat dissipation cavity 100 for dissipation. Therefore, air-cooled heat dissipation for the first power device 50 is indirectly implemented.

It should be noted herein that, FIG. 19 merely shows an example of quantities and specific locations of the air outlets 33 and the first air inlets 321. In actual implementation, there may be one or more air outlets 33. The one or more air outlets 33 may be disposed on any one or more of the first side surface 1011, the second side surface 1012, the third side surface 1013, and the fourth side surface 1014. Similarly, there may also be one or more first air inlets 321. The one or more first air inlets 321 may also be disposed on any one or more of the first side surface 1011, the second side surface 1012, the third side surface 1013, and the fourth side surface 1014. In other words, in actual implementation, it only needs to be ensured that the first air inlets 321 and the air outlets 33 are disposed at the top 102, and that the air-cooled channel 31 can pass through the first condenser 201. The quantities and specific locations of the air outlets 33 and the first air inlets 321 are not limited in this application.

In the foregoing implementation, the first fan 34 is disposed above the first condenser 201. The first air inlets 321 are respectively disposed on surfaces of the first condenser 201. The air outlets 33 are respectively disposed on the surfaces of the first fan 34. In this way, the airflow in the air-cooled channel 31 can be in full contact with the first condenser 201, and efficient air-cooled heat dissipation for the first condenser 201 can be implemented. In addition, based on such a structure, subsequent maintenance of the first fan 34 can also be facilitated.

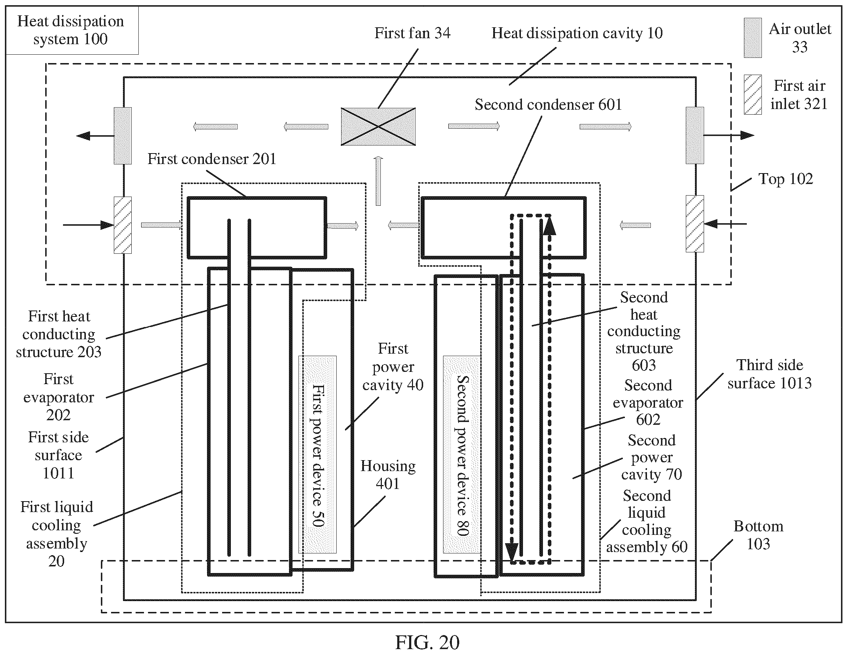

Optionally, with reference to the structure of the air cooling assembly 30 shown in FIG. 19, further refer to FIG. 20. FIG. 20 is a schematic diagram of another structure of a heat dissipation system according to an embodiment of this application. As shown in FIG. 20, the heat dissipation system 100 may further include a second liquid cooling assembly 60, a second power cavity 70, and a second power device 80. A structure of the second liquid cooling assembly 60 may be the same as the structure of the first liquid cooling assembly 20. The second liquid cooling assembly 60 may specifically include a second condenser 601, a second evaporator 602, and a second heat conducting structure 603. The second condenser 601 is connected to the second evaporator 602 through the second heat conducting structure 603. The second condenser 601 is disposed at the top 102 of the heat dissipation cavity 102, and is located on a side of the first condenser 201 (in other words, the second condenser 601 is located on a side that is of the first condenser 201 and that faces the first side surface 1011 or the third side surface 1013, and FIG. 20 shows an example in which the second condenser 601 is located on the side that is of the first condenser 201 and that faces the third side surface 1013). In this way, the air-cooled channel 31 further passes through the second condenser 601. The second power device 80 is disposed inside the second power cavity 70. The second power cavity 70 is in contact with the second evaporator 602. Moreover, both the second power cavity 70 and the second evaporator 602 are disposed below the second condenser 601. Herein, an internal structure of the second liquid cooling assembly 60 and a relative location relationship between the second liquid cooling assembly 60, the second power cavity 70, and the second power device 80 are respectively the same as the internal structure of the first liquid cooling assembly 20 and the relative location relationship between the first liquid cooling assembly 20, the first power cavity 40, and the first power device 50 described above. Reference may be made to the foregoing descriptions. Details are not described herein again.

In actual working, the second liquid cooling assembly 60 may be configured to perform liquid-cooled heat dissipation on the second power device 80. For a specific working process of the second liquid cooling assembly 60, reference may be made to the foregoing description of a working process of the first liquid cooling assembly 20. Details are not described herein again. Moreover, when the first fan 34 works normally, airflow that enters first air inlets 323 further passes through the second condenser 601, to bring, through the airflow, heat of the second condenser 601 to the outside of the heat dissipation cavity 10 for dissipation. Therefore, air-cooled heat dissipation for the second power device 80 is implemented.

In the foregoing implementation, the second liquid cooling assembly 60 that has a same structure as the first liquid cooling assembly 20 is further disposed inside the heat dissipation cavity 10. In this way, the heat dissipation system 100 can dissipate heat for both the first power device 50 and the second power device 80 through the first liquid cooling assembly 20, the air cooling assembly 30, and the second liquid cooling assembly 60, so that a load capability of the heat dissipation system 100 is greater, and a heat dissipation capability of the heat dissipation system 100 may be improved.

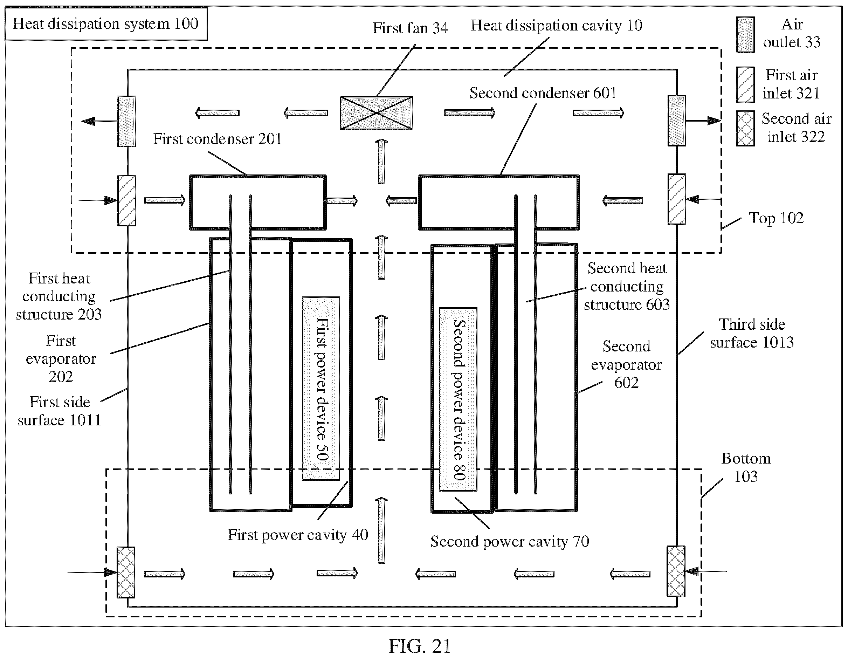

Further, optionally, FIG. 21 is a schematic diagram of another structure of a heat dissipation system according to an embodiment of this application. As shown in FIG. 21, the air inlets 32 may further include second air inlets 322. The second air inlets 322 may be disposed at the bottom 103. It should be understood that FIG. 21 shows an example in which there are two second air inlets 324 that are respectively disposed on the first side surface 1011 and the third side surface 1013. In this way, airflow outside the heat dissipation cavity 10 can further enter the heat dissipation cavity 10 through the second air inlets 322, is blown through any two of the first evaporator 202, the first power cavity 40, the second evaporator 602, and the second power cavity 70 under an action of the first fan 34, and finally returns to the outside of the heat dissipation cavity 10 through the air outlets 33.

In actual working, when the first evaporator 202 faces away from the first power cavity 40 and faces the first side surface 1011, and the second evaporator 602 faces away from the second power cavity 70 and faces the third side surface 1013, the air-cooled channel 31 further passes through the first power cavity 40 and the second power cavity 70. Under the action of the first fan 34, the airflow that enters the second air inlets 322 is blown through the first power cavity 40 and the second power cavity 70, to bring the first power cavity 40 and the second power cavity 70 to the outside of the heat dissipation cavity for dissipation. Therefore, air-cooled heat dissipation for the first power device 50 and the second power device 80 is indirectly implemented.

When the first evaporator 202 faces away from the first power cavity 40 and faces the first side surface 1011, and the second power cavity 70 faces away from the second evaporator 602 and faces the third side surface 1013, the air-cooled channel 31 further passes through the first power cavity 40 and the second evaporator 602. Under the action of the first fan 34, the airflow that enters the second air inlets 322 is blown through the first power cavity 40 and the second evaporator 602, to bring the first power cavity 40 and the second evaporator 602 to the outside of the heat dissipation cavity for dissipation. Therefore, air-cooled heat dissipation for the first power device 50 and the second power device 80 is indirectly implemented.

When the first power cavity 40 faces away from the first evaporator 202 and faces the first side surface 1011, and the second power cavity 70 faces away from the second evaporator 602 and faces the third side surface 1013, the air-cooled channel 31 further passes through the first evaporator 202 and the second evaporator 602. Under the action of the first fan 34, the airflow that enters the second air inlets 322 is blown through the first evaporator 202 and the second evaporator 602, to bring the first evaporator 202 and the second evaporator 602 to the outside of the heat dissipation cavity for dissipation. Therefore, air-cooled heat dissipation for the first power device 50 and the second power device 80 is indirectly implemented.

When the first power cavity 40 faces away from the first evaporator 202 and faces the first side surface 1011, and the second evaporator 602 faces away from the second power cavity 70 and faces the third side surface 1013, the air-cooled channel 31 further passes through the first evaporator 202 and the second power cavity 70. Under the action of the first fan 34, the airflow that enters the second air inlets 322 is blown through the first evaporator 202 and the second power cavity 70, to bring the first evaporator 202 and the second power cavity 70 to the outside of the heat dissipation cavity for dissipation. Therefore, air-cooled heat dissipation for the first power device 50 and the second power device 80 is indirectly implemented.

Similarly, FIG. 21 merely shows an example of a quantity and specific locations of the second air inlets 322. In actual implementation, there may be one or more second air inlets 322. The one or more second air inlets 322 may be disposed on any one or more of the first side surface 1011, the second side surface 1012, the third side surface 1013, and the fourth side surface 1014. In other words, under a framework shown in FIG. 21, it only needs to be ensured that the second air inlets 324 are disposed at the bottom 103, first air inlets 323 and the air outlets 33 are disposed at the top 102, and that the air-cooled channel 31 passes through the first condenser 201 and the second condenser 601, and further passes through any two of the first evaporator 202, the second evaporator 602, the first power cavity 40, and the second power cavity 70. A quantity and specific locations of the second air inlets 324 are not limited herein.

In the foregoing implementation, after the second air inlets 324 are additionally disposed at the bottom 103, the air-cooled channel 31 passes through the first condenser 201 and the second condenser 601, and further passes through any two of the first evaporator 202, the second evaporator 602, the first power cavity 40, and the second power cavity 70. In this way, the air cooling assembly 30 can not only perform air-cooled heat dissipation on the first condenser 201 and the second condenser 601, but also perform heat dissipation on any two of the first evaporator 202, the second evaporator 602, the first power cavity 40, and the second power cavity 70, thereby effectively improving heat dissipation efficiency of the heat dissipation system 100.

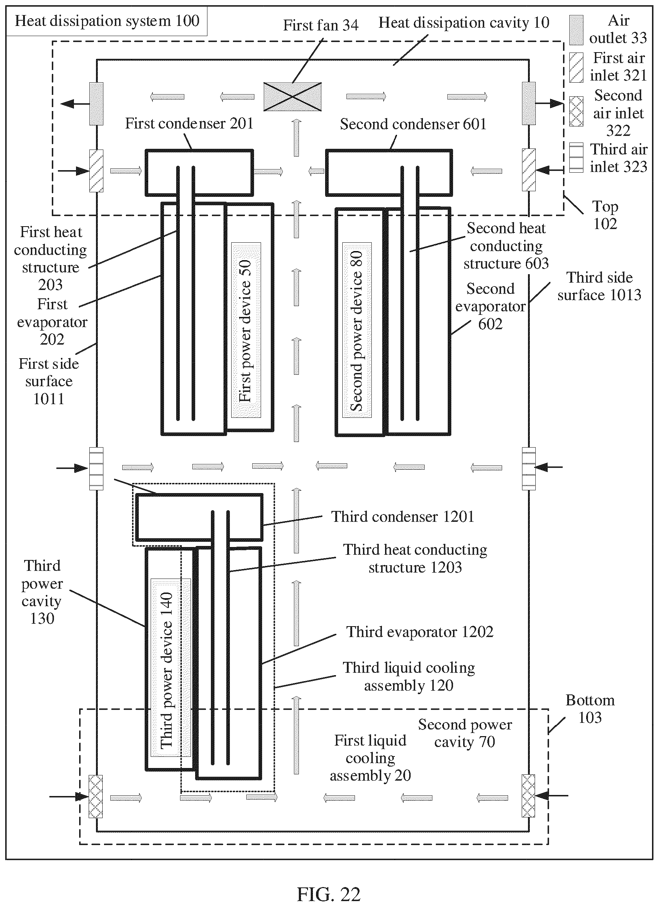

Further, optionally, FIG. 22 is a schematic diagram of another structure of a heat dissipation system according to an embodiment of this application. As shown in FIG. 22, the heat dissipation system 100 may further include a third liquid cooling assembly 120, a third power cavity 130, and a third power device 140. A structure of the third liquid cooling assembly 120 may be the same as the structure of the first liquid cooling assembly 20. The third liquid cooling assembly 120 may specifically include a third condenser 1201, a third evaporator 1202, and a third heat conducting structure 1203. The third condenser 1201 is connected to the third evaporator 1202 through the third heat conducting structure 1203. The third condenser 1201 is disposed below the first liquid cooling assembly 20, and is located above the second air inlets 322 (which may be alternatively understood as that the entire third liquid cooling assembly 120 and the third power cavity 130 are located below the first liquid cooling assembly). In this way, the air-cooled channel 31 may further pass through the third condenser 1201 and the third evaporator 1202 or the third power cavity 130. The third power cavity 130 is in contact with the third evaporator 1202 of the third liquid cooling assembly 120. The third power device 140 is disposed inside the third power cavity 130. Moreover, both the third power cavity 130 and the third evaporator 1202 are disposed below the third condenser 1201. Herein, an internal structure of the third liquid cooling assembly 120 and a relative location relationship between the third liquid cooling assembly 120, the third power cavity 130, and the third power device 140 are respectively the same as the internal structure of the first liquid cooling assembly 20 and the relative location relationship between the first liquid cooling assembly 20, the first power cavity 40, and the first power device 50 described above. Reference may be made to the foregoing descriptions. Details are not described herein again.

In actual working, the third liquid cooling assembly 120 may be configured to perform liquid-cooled heat dissipation on the third power device 140. For a specific working process of the third liquid cooling assembly 120, reference may be made to the foregoing description of a working process of the first liquid cooling assembly 20. Details are not described herein again. Moreover, when the third power cavity 130 faces away from the third evaporator 1202 and faces the first side surface 1011, the air-cooled channel 31 further passes through the third condenser 1201 and the third evaporator 1202, and the airflow in the air-cooled channel 31 may be further used to bring heat of the third condenser 1201 and the third evaporator 1202 to the outside of the heat dissipation cavity 10 for dissipation. Therefore, air-cooled heat dissipation for the third power device 140 is implemented. When the third evaporator 1202 faces away from the third power cavity 130 and faces the first side surface 1011, the air-cooled channel 31 further passes through the third condenser 1201 and the third power cavity 130, and the airflow in the air-cooled channel 31 may be further used to bring heat of the third condenser 1201 and the third power cavity 130 to the outside of the heat dissipation cavity 10 for dissipation. Therefore, air-cooled heat dissipation for the third power device 140 is implemented.

In the foregoing implementation, the third liquid cooling assembly 120 that has a same structure as the first liquid cooling assembly 20 is further disposed inside the heat dissipation cavity 10. In addition, the third liquid cooling assembly 120 and the first liquid cooling assembly 20 are placed inside the heat dissipation cavity 10 in a stacked structure. Based on such a structure design, internal space of the heat dissipation cavity 10 can be effectively utilized. In addition, the heat dissipation system 100 can dissipate heat for the first power device 50, the second power device 80, and the third power device 140 in combination with the first liquid cooling assembly 20, the air cooling assembly 30, the second liquid cooling assembly 60, and the third liquid cooling assembly 120, thereby further improving the load capability of the heat dissipation system 100.

Further, still refer to FIG. 22. As shown in FIG. 22, the air inlets 32 may further include third air inlets 323. The third air inlets 323 are respectively disposed below the first air inlets 321, and are respectively located on side surfaces of the third condenser 1201. It should be understood that FIG. 22 shows an example in which there are two third air inlets 323 that are respectively disposed on surfaces that are of the third condenser 1201 and that respectively face the first side surface 1011 and the third side surface 1013.

In actual working, the first fan 34 may further bring, through the air-cooled channel 31, airflow that enters the third air inlets 323 to the air outlets 33, and finally blows the airflow to the outside of the heat dissipation cavity 10 through the air outlets 33. In this way, an air intake volume of the air-cooled channel 31 may be further increased, a heat dissipation capability of the air cooling assembly 30 is improved, and then heat dissipation efficiency of the heat dissipation system 100 is improved.

Similarly, FIG. 22 merely shows an example of a quantity and specific locations of the third air inlets 323. In actual implementation, there may be one or more third air inlets 323. The one or more third air inlets 323 may be disposed on any one or more of the first side surface 1011, the second side surface 1012, the third side surface 1013, and the fourth side surface 1014. In other words, under a framework shown in FIG. 22, it only needs to be ensured that the third air inlets 323 are disposed on side surfaces of the third condenser 1201. A quantity and specific locations of the third air inlets 323 are not limited herein.

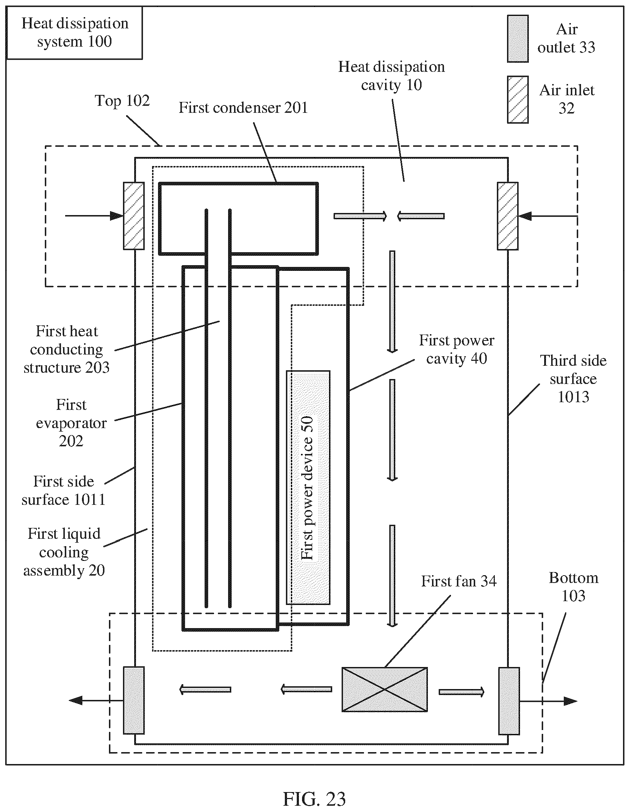

In some feasible implementations, FIG. 23 is a schematic diagram of another structure of a heat dissipation system according to an embodiment of this application. As shown in FIG. 23, the air cooling assembly 30 may further include a first fan 34. The air inlets 32 may be disposed at the top 102, and are respectively located on side surfaces of the first condenser 201 (it should be understood that FIG. 23 shows an example in which there are two air inlets 32 that are respectively disposed on the first side surface 1011 and the third side surface 1013). The air outlets 33 and the first fan 34 may be disposed at the bottom 103, and both are located below the first liquid cooling assembly 20 (it should be understood that FIG. 23 shows an example in which there are two air outlets 33 that are respectively disposed on the first side surface 1011 and the third side surface 1013). In such a structure, when the first evaporator 202 faces away from the first power cavity 40 and faces the first side surface 1011 (that is, the structure shown in FIG. 23), the air-cooled channel 31 passes through the first condenser 201 and the first power cavity 40. When the first power cavity 40 faces away from the first evaporator 202 and faces the first side surface 1011, the air-cooled channel 31 passes through the first condenser 201 and the first evaporator 202.

In actual working, the first fan 34 may blow air to the air outlets 33, to bring, through the air-cooled channel 31, airflow that enters the air inlets 32 to the air outlets 33, and blows the airflow to the outside of the heat dissipation cavity 10 through the air outlets 33. When the air-cooled channel 31 passes through the first condenser 201 and the first power cavity 40, the airflow in the air-cooled channel 31 may bring heat of the first condenser 201 and the first power cavity 40 to the outside of the heat dissipation cavity 100 for dissipation. Therefore, air-cooled heat dissipation for the first power device 50 is implemented. When the air-cooled channel 31 passes through the first condenser 201 and the first evaporator 202, the airflow in the air-cooled channel 31 may bring heat of the first condenser 201 and the first evaporator 202 to the outside of the heat dissipation cavity 100 for dissipation. Therefore, air-cooled heat dissipation for the first power device 50 is implemented.

In the foregoing implementation, the first fan 34 and the air outlets 33 are disposed below the first liquid cooling assembly 20, and the air inlets 32 are disposed on the side surfaces of the first condenser 201. In this way, the air-cooled channel 31 may pass through the first condenser 102 and further pass through the first power cavity 40 or the first evaporator 202. Therefore, the air cooling assembly 30 can not only dissipate heat for the first condenser 201, but also dissipate heat for the first power cavity 40 or the first evaporator 202, thereby improving heat dissipation efficiency of the heat dissipation system 100.

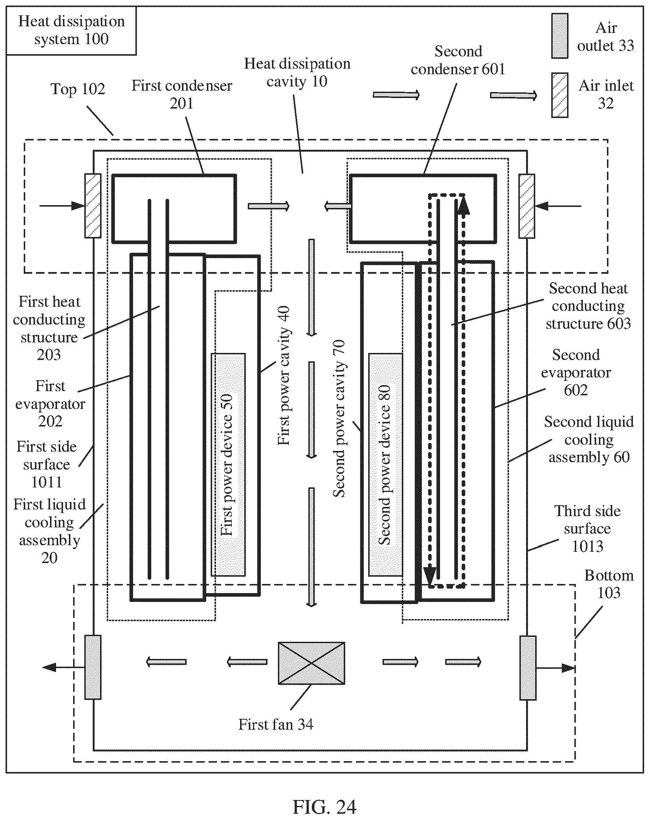

Optionally, with reference to the structure of the air cooling assembly 30 shown in FIG. 23, further refer to FIG. 24. FIG. 24 is a schematic diagram of another structure of a heat dissipation system according to an embodiment of this application. As shown in FIG. 24, the heat dissipation system 100 may further include a second liquid cooling assembly 60, a second power cavity 70, and a second power device 80. A structure of the second liquid cooling assembly 60 may be the same as the structure of the first liquid cooling assembly 20. The second liquid cooling assembly 60 may specifically include a second condenser 601, a second evaporator 602, and a second heat conducting structure 603. The second condenser 601 is connected to the second evaporator 602 through the second heat conducting structure 603. The second condenser 601 is disposed at the top 102 of the heat dissipation cavity 102, and is located on a side surface of the first condenser 201 (in other words, the second condenser 601 is located on a side that is of the first condenser 201 and that faces the first side surface 1011 or the third side surface 1013, and FIG. 24 shows an example in which the second condenser 601 is located on the side that is of the first condenser 201 and that faces the third side surface 1013). The second power device 80 is disposed inside the second power cavity 70. The second power cavity 70 is in contact with the second evaporator 602. Moreover, both the second power cavity 70 and the second evaporator 602 are disposed below the second condenser 601. Herein, an internal structure of the second liquid cooling assembly 60 and a relative location relationship between the second liquid cooling assembly 60, the second power cavity 70, and the second power device 80 are respectively the same as the internal structure of the first liquid cooling assembly 20 and the relative location relationship between the first liquid cooling assembly 20, the first power cavity 40, and the first power device 50 described above. Reference may be made to the foregoing descriptions. Details are not described herein again.

It may be understood that when the second evaporator 602 faces away from the second power cavity 70 and faces the third side surface 1013 (that is, the structure shown in FIG. 24), the air-cooled channel 31 may further pass through the second condenser 601 and the second power cavity 70. When the second power cavity 70 faces away from the second evaporator 602 and faces the third side surface 1013, the air-cooled channel 31 further passes through the second condenser 601 and the second evaporator 602.

In actual working, the second liquid cooling assembly 60 may be configured to perform liquid-cooled heat dissipation on the second power device 80. For a specific working process of the second liquid cooling assembly 60, reference may be made to the foregoing description of a working process of the first liquid cooling assembly 20. Details are not described herein again. Moreover, when the first fan 34 works normally and the air-cooled channel 31 further passes through the second condenser 601 and the second power cavity 70, the airflow in the air-cooled channel 31 may be further used to bring heat of the second condenser 601 and the second power cavity 70 to the outside of the heat dissipation cavity 100 for dissipation. Therefore, air-cooled heat dissipation for the second power device 80 is implemented. When the air-cooled channel 31 further passes through the second condenser 601 and the second evaporator 602, the airflow in the air-cooled channel 31 may be further used to bring heat of the second condenser 601 and the second evaporator 602 to the outside of the heat dissipation cavity 100 for dissipation. Therefore, air-cooled heat dissipation for the second power device 80 is implemented.

In the foregoing implementation, the second liquid cooling assembly 60 that has a same structure as the first liquid cooling assembly 20 is further disposed inside the heat dissipation cavity 10. In this way, the heat dissipation system 100 can dissipate heat for both the first power device 50 and the second power device 80 through the first liquid cooling assembly 20, the air cooling assembly 30, and the second liquid cooling assembly 40, so that a load capability of the heat dissipation system 100 is greater, and a heat dissipation capability of the heat dissipation system 100 may be improved.

It should be noted herein that, FIG. 23 and FIG. 24 merely show examples of quantities and specific locations of the air outlets 33 and the air inlets 32. In actual implementation, there may be one or more air outlets 33. The one or more air outlets 33 may be disposed on any one or more of the first side surface 1011, the second side surface 1012, the third side surface 1013, and the fourth side surface 1014. Similarly, there may also be one or more air inlets 32. The one or more air inlets 32 may also be disposed on any one or more of the first side surface 1011, the second side surface 1012, the third side surface 1013, and the fourth side surface 1014. In other words, under a system framework shown in FIG. 23 or FIG. 24, it only needs to be ensured that the first fan 34 and the air outlets 33 are disposed at the bottom 103, the air inlets 32 are disposed at the top 102, and that the air-cooled channel 31 can pass through one or more of the first liquid cooling assembly 20, the second liquid cooling assembly 60, the first power cavity 40, and the second power cavity 70. Quantities and specific locations of the air outlets 33 and the air inlets 32 are not limited herein.

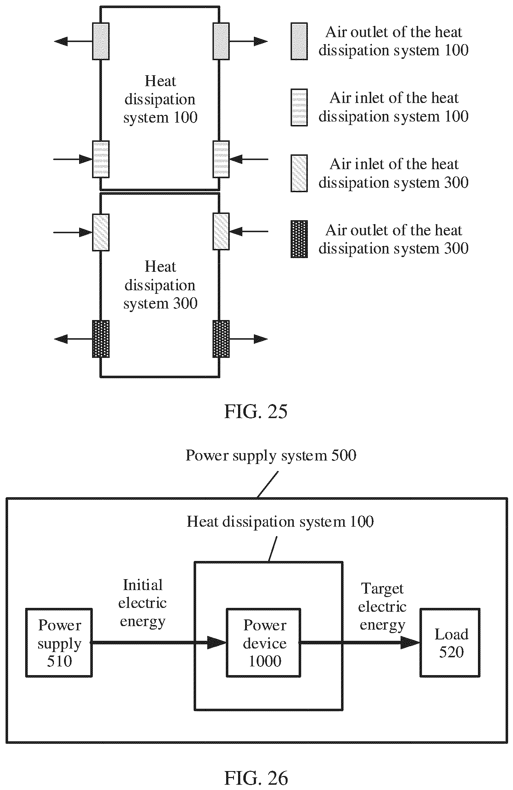

In some feasible implementations, FIG. 25 is a schematic diagram of an application scenario according to an embodiment of this application. As shown in FIG. 25, the heat dissipation system 100 is stacked with another heat dissipation system 300 for use. In addition, the heat dissipation system 100 is located above the heat dissipation system 300. In such a working scenario, air inlets (for example, the air inlets 32 described above) of the heat dissipation system 100 should be as far away as possible from air outlets of the heat dissipation system 300. As shown in FIG. 25, it is assumed that the air inlets of the heat dissipation system 100 are disposed at a bottom of the heat dissipation system 100, and the air outlets of the heat dissipation system 300 should also be disposed at a bottom of the heat dissipation system 300. In this way, hot air blown out of the air outlets of the heat dissipation system 300 can be prevented from flowing into the air inlets of the heat dissipation system 100, thereby avoiding that heat dissipation efficiency of the heat dissipation system 100 is affected by the heat dissipation system 300. Herein, an internal structure of the heat dissipation system 300 may be the same as or different from that of the heat dissipation system 100. This is not limited herein. For example, when the internal structure of the heat dissipation system 100 is as shown in FIG. 21, the internal structure of the heat dissipation system 300 may be as shown in FIG. 23. In this way, the heat dissipation efficiency of the heat dissipation system 100 can be prevented from being affected by the heat dissipation system 300.

It should be additionally noted that, during actual implementation, shapes of a heat dissipation cavity, a condenser, an evaporator, and a power cavity in embodiments of this application may be a cuboid, a cube, a cylinder, or the like. The shapes of these structures may be determined based on an actual application requirement. This is not limited in this application. A cooling working substance in embodiments of this application may also be referred to as a coolant, and may be specifically water, a nitriding liquid, or the like. This is not specifically limited in this application. A heat conducting structure in embodiments of this application (for example, the first heat conducting structure 203 or the second heat conducting structure 603) may be specifically a siphon heat pipe, a gravity heat pipe, a loop heat pipe, or a high heat conducting component of another structure. Types of these heat conducting structures may be selected based on an actual design requirement. This is not specifically limited in this application. A fan in embodiments of this application (for example, the first fan 34 and the second fan 35 described above) may be specifically a centrifugal fan, an axial fan, a cross-flow fan, or the like. Types of these fans may be selected based on an actual design requirement. This is not specifically limited in this application.

It should be additionally noted that, in the foregoing embodiments, a specific description of a technical feature in an optional implementation may also be applied to explain a corresponding technical feature mentioned in another optional implementation. For example, based on FIG. 5 and FIG. 6, it is described in the foregoing that the heat sink fins 402 may be disposed on the housing 401 of the first power cavity 40, and the first power device 50 may include a plurality of power sub-devices. This feature is also applicable to the following descriptions of the second power cavity 70, the third power cavity 130, the second power device 80, and the third power device 140. In other words, in the foregoing embodiments, different specific structures of the components or modules in the heat dissipation system 100 may be combined with each other. Solutions obtained by combining the specific structures with each other should fall within the protection scope of this application.

An embodiment of this application further provides a power supply system that dissipates heat by using the foregoing heat dissipation system 100. FIG. 26 is a schematic diagram of a structure of a power supply system according to an embodiment of this application. As shown in FIG. 26, the power supply system 500 may include a power supply 510, the heat dissipation system 100 described above, and a load 520. A power device 1000 in the heat dissipation system 100 (for example, the first power device 50 and the second power device 80 described above) is connected to both the power supply 510 and the load 520. In actual working, the power device 1000 may be configured to convert initial electric energy provided by the power supply 510 into target electric energy. Herein, a current value and a voltage value of the target electric energy may be preset values. Then, the power device 1000 may supply power to the load 520 by using the target electric energy.

It should be noted herein that, in actual use, the load 520 may be specifically a power-consuming device such as an electric vehicle, a robot, or an electric forklift, and the heat dissipation system 100 may be specifically a power supply device such as a charging pile or a charging station.

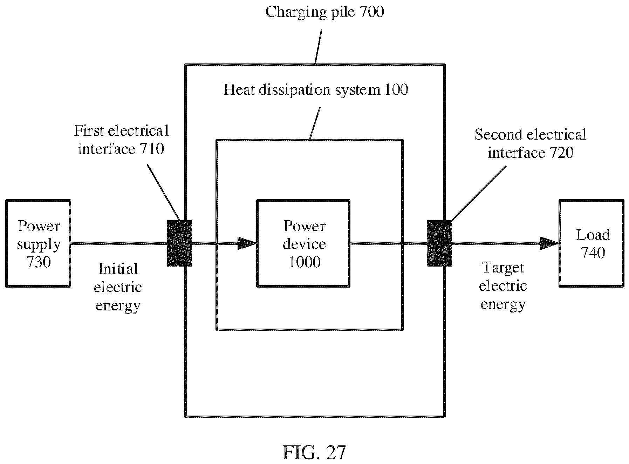

An embodiment of this application further provides a charging pile that dissipates heat by using the foregoing heat dissipation system 100. FIG. 27 is a schematic diagram of a structure of a charging pile according to an embodiment of this application. As shown in FIG. 27, the charging pile 700 includes a first electrical interface 710, a second electrical interface 720, and the heat dissipation system 100 described above. A power device 1000 in the heat dissipation system 100 (for example, the first power device 50 and the second power device 80 described above) is connected to both the first electrical interface 710 and the second electrical interface 720. In actual working, the heat dissipation system 100 is configured to dissipate heat for the power device 1000. The power device 1000 is configured to: convert initial electric energy input by the first electrical interface 710 into target electric energy, and output the target electric energy through the second electrical interface 720. Herein, a current value and a voltage value of the target electric energy may be preset values. There may be one or more first electrical interfaces 710 and second electrical interfaces 720. This is not specifically limited in this application.

In an optional implementation, the power device 1000 may be specifically a DC/DC conversion module or an AC/DC conversion module.

In an optional implementation, as shown in FIG. 27, the first electrical interface 710 may be connected to a power supply 730, to obtain the initial electric energy from the power supply 730. The second electrical interface 720 may be connected to a load 740, to supply power to the load by using the target electric energy.

In an optional implementation, the power supply 730 may be specifically an alternating current power grid, a photovoltaic array, or the like. The load 740 may be specifically a power-consuming device such as an electric vehicle, a robot, or an electric forklift.

In this embodiment of this application, a liquid cooling assembly and an air cooling assembly are integrated in a heat dissipation cavity 10 of the heat dissipation system 100. The power device that generates heat is placed inside a power cavity that is in direct contact with the liquid cooling assembly. An air-cooled channel corresponding to the air cooling assembly is designed as passing through the liquid cooling assembly and/or the power cavity. In this way, the liquid cooling assembly and the air cooling assembly may simultaneously dissipate heat for the power device, so that heat dissipation efficiency of the heat dissipation system 100 may be relatively high. In addition, the power cavity is further used to protect the power device, so that a fault of the power device caused by factors such as an environment can be effectively avoided, reliability of the heat dissipation system is improved, and subsequent maintenance costs can also be reduced. Therefore, the heat dissipation system 100 provided in this application has high applicability. Based on the heat dissipation system 100, problems of low heat dissipation efficiency, poor reliability, and high maintenance costs in an existing heat dissipation system can be effectively resolved.

In embodiments provided in this application, it should be understood that the disclosed system, apparatus, or method may be implemented in another manner. For example, the described apparatus embodiments are merely examples. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in embodiments of this application may be integrated into one processing unit, each of the units may exist alone physically, or two or more units are integrated into one unit.

In the specification, claims, and accompanying drawings of this application, terms "first", "second", "third", "fourth", and the like are intended to distinguish between different objects but do not indicate a particular order. In addition, terms "include", "have" and any other variants thereof are intended to cover a non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the product, or the device.

An "embodiment" mentioned in this specification means that a particular feature, structure, or characteristic described with reference to this embodiment may be included in at least one embodiment of this application. The phrase shown in various locations in this specification may not necessarily refer to a same embodiment, and is not an independent or optional embodiment exclusive from another embodiment. It is explicitly and implicitly understood by a person skilled in the art that embodiments described in this specification may be combined with another embodiment.

In the foregoing specific implementations, the objectives, technical solutions, and beneficial effects of this application are further described in detail. It should be understood that the foregoing descriptions are merely specific implementations of this application, but are not intended to limit the protection scope of this application. Any modification, equivalent replacement, improvement, or the like made based on the technical solutions of this application shall fall within the protection scope of this application.

## Claims

1. A heat dissipation system, wherein the heat dissipation system comprises a heat dissipation cavity, a first liquid cooling assembly, an air cooling assembly, a first power cavity, and a first power device, the first liquid cooling assembly and the first power cavity are disposed inside the heat dissipation cavity, the first power device is disposed inside the first power cavity, the first power cavity is in contact with the first liquid cooling assembly, an air inlet and an air outlet of the air cooling assembly are disposed on the heat dissipation cavity, and airflow in an air-cooled channel connected between the air inlet and the air outlet passes through the first liquid cooling assembly and/or the first power cavity; and
the first liquid cooling assembly and the air cooling assembly are configured to dissipate heat for the first power device.

2. The heat dissipation system according to claim 1, wherein the first liquid cooling assembly comprises a first condenser, a first evaporator, and a first heat conducting structure, the first condenser is disposed at a top of the heat dissipation cavity, and the first evaporator is in contact with the first power cavity and is disposed below the first condenser; and
the first heat conducting structure connects the first evaporator and the first condenser to form a circulation loop, and a cooling working substance circulating in the circulation loop is used to bring heat of the first evaporator to the first condenser.

3. The heat dissipation system according to claim 2, wherein a heat sink fin is disposed on a surface that is of the first power cavity and that is not in contact with the first evaporator.

4. The heat dissipation system according to claim 2 or 3, wherein the air cooling assembly further comprises a first fan, the air inlet and the first fan are disposed at a bottom of the heat dissipation cavity and are located below the first liquid cooling assembly, and the air outlet is disposed at the top of the heat dissipation cavity; and
the first fan is configured to bring, through the air-cooled channel, airflow that enters the air inlet to the air outlet, and the airflow in the air-cooled channel passes through the first condenser and the first power cavity, to bring heat of the first condenser and the first power cavity to the outside of the heat dissipation cavity; or
the first fan is configured to bring, through the air-cooled channel, airflow that enters the air inlet to the air outlet, and the airflow in the air-cooled channel passes through the first condenser and the first evaporator, to bring heat of the first condenser and the first evaporator to the outside of the heat dissipation cavity.

5. The heat dissipation system according to claim 4, wherein the heat dissipation system further comprises a second liquid cooling assembly, a second power cavity, and a second power device, a second condenser of the second liquid cooling assembly is disposed at the top of the heat dissipation cavity and is located on a side of the first liquid cooling assembly, the second power cavity is in contact with a second evaporator of the second liquid cooling assembly, and the second power device is disposed inside the second power cavity; and
the airflow in the air-cooled channel further passes through the second condenser and the second power cavity, to bring heat of the second condenser and the second power cavity to the outside of the heat dissipation cavity; or
the airflow in the air-cooled channel further passes through the second condenser and the second evaporator, to bring heat of the second condenser and the second evaporator to the outside of the heat dissipation cavity.

6. The heat dissipation system according to claim 2 or 3, wherein the air cooling assembly further comprises a first fan, the air inlet is disposed at a bottom of the heat dissipation cavity and is located on a first side of the first liquid cooling assembly, the air outlet is disposed at the top of the heat dissipation cavity and is located on a second side that is of the first liquid cooling assembly and that is opposite to the first side, and the first fan is disposed on the first side of the first liquid cooling assembly; and
the first fan is configured to bring, through the air-cooled channel, airflow that enters the air inlet to the air outlet, and the airflow in the air-cooled channel passes through the first condenser and the first power cavity, to bring heat of the first condenser and the first power cavity to the outside of the heat dissipation cavity; or
the first fan is configured to bring, through the air-cooled channel, airflow that enters the air inlet to the air outlet, and the airflow in the air-cooled channel passes through the first condenser and the first evaporator, to bring heat of the first condenser and the first evaporator to the outside of the heat dissipation cavity.

7. The heat dissipation system according to claim 6, wherein the heat dissipation system further comprises a second liquid cooling assembly, a second power cavity, and a second power device, a second condenser of the second liquid cooling assembly is disposed on a side that is of the first condenser and that faces the air outlet, the second power cavity is in contact with a second evaporator of the second liquid cooling assembly, and the second power device is disposed inside the second power cavity; and
the airflow in the air-cooled channel further passes through the second condenser, to bring heat of the second condenser to the outside of the heat dissipation cavity.

8. The heat dissipation system according to claim 2 or 3, wherein the air cooling assembly further comprises a first fan, the air inlet comprises a first air inlet, the first air inlet, the air outlet, and the first fan are disposed at the top of the heat dissipation cavity, the first air inlet is disposed on a first side of the first condenser, the first fan is disposed on a second side that is of the first condenser and that is opposite to the first side, and the air outlet is disposed on a side that is of the first fan and that faces away from the first condenser; and
the first fan is configured to bring, through the air-cooled channel, airflow that enters the first air inlet to the air outlet, and the airflow in the air-cooled channel passes through the first condenser, to bring heat of the first condenser to the outside of the heat dissipation cavity.

9. The heat dissipation system according to claim 8, wherein the heat dissipation system further comprises a second liquid cooling assembly, a second power cavity, and a second power device, a second condenser of the second liquid cooling assembly is disposed on a side that is of the first fan and that faces the air outlet, the second power cavity is in contact with a second evaporator of the second liquid cooling assembly, and the second power device is disposed inside the second power cavity; and
the airflow in the air-cooled channel further passes through the second condenser, to bring heat of the second condenser to the outside of the heat dissipation cavity.

10. The heat dissipation system according to claim 8, wherein the heat dissipation system further comprises a second liquid cooling assembly, a second power cavity, and a second power device, a second condenser of the second liquid cooling assembly is disposed on a side that is of the first condenser and that faces away from the air outlet, the second power cavity is in contact with a second evaporator of the second liquid cooling assembly, and the second power device is disposed inside the second power cavity; and
the airflow in the air-cooled channel further passes through the second condenser, to bring heat of the second condenser to the outside of the heat dissipation cavity.

11. The heat dissipation system according to claim 10, wherein a first air baffle is disposed between a first cavity and a second cavity of the heat dissipation cavity, and the first air baffle is configured to block ventilation between the first cavity and the second cavity, wherein
the first cavity is a cavity that is comprised in the heat dissipation cavity and that is located on a side that is of the first condenser and that faces the air outlet, and the second cavity is a cavity that is comprised in the heat dissipation cavity and that is located on a side that is of the first power cavity or the first evaporator and that faces away from the second liquid cooling assembly.

12. The heat dissipation system according to claim 2 or 3, wherein the air cooling assembly further comprises a first fan, the air outlet comprises a first air outlet, the air inlet is disposed at a bottom of the heat dissipation cavity, the first air outlet is disposed at the top of the heat dissipation cavity, the first fan is disposed on a side that is of the first condenser and that faces the first air outlet, a first air baffle is disposed between a first cavity and a second cavity of the heat dissipation cavity, the first air baffle is configured to block ventilation between the first cavity and the second cavity, the first cavity is a cavity that is comprised in the heat dissipation cavity and that is located on the side that is of the first condenser and that faces the first air outlet, and the second cavity is a cavity that is comprised in the heat dissipation cavity and that is located on a side that is of the first power cavity or the first evaporator and that faces away from a second liquid cooling assembly; and
the first fan is configured to bring, through the air-cooled channel, airflow that enters the air inlet to the first air outlet, and the airflow in the air-cooled channel passes through the first condenser and the first evaporator, to bring heat of the first condenser and the first evaporator to the outside of the heat dissipation cavity; or
the first fan is configured to bring, through the air-cooled channel, airflow that enters the air inlet to the first air outlet, and the airflow in the air-cooled channel passes through the first condenser and the first power cavity, to bring heat of the first condenser and the first cavity to the outside of the heat dissipation cavity.

13. The heat dissipation system according to claim 12, wherein the heat dissipation system further comprises a second liquid cooling assembly, a second power cavity, and a second power device, the air cooling assembly further comprises a second fan, the air outlet further comprises a second air outlet, a second condenser of the second liquid cooling assembly is disposed on a side that is of the first condenser and that faces away from the first fan, the second power cavity is in contact with a second evaporator of the second liquid cooling assembly, the second power device is disposed inside the second power cavity, the second fan is located on a side that is of the second condenser and that faces away from the first condenser, the second air outlet is disposed at the top of the heat dissipation cavity, a second air baffle is disposed between a third cavity and a fourth cavity of the heat dissipation cavity, the second air baffle is configured to block ventilation between the third cavity and the fourth cavity, the third cavity is a cavity that is comprised in the heat dissipation cavity and that is located on a side that is of the second condenser and that faces the second air outlet, and the fourth cavity is a cavity that is comprised in the heat dissipation cavity and that is located on a side that is of the second power cavity and the second evaporator and that faces away from the first liquid cooling assembly; and
the second fan is configured to bring, through the air-cooled channel, airflow that enters the air inlet to the second air outlet, and the airflow in the air-cooled channel further passes through the second condenser and the second evaporator, to bring heat of the second condenser and the second evaporator to the outside of the heat dissipation cavity; or
the second fan is configured to bring, through the air-cooled channel, airflow that enters the air inlet to the second air outlet, and the airflow in the air-cooled channel further passes through the second condenser and the second power cavity, to bring heat of the second condenser and the second cavity to the outside of the heat dissipation cavity.

14. The heat dissipation system according to claim 2 or 3, wherein the air cooling assembly further comprises a first fan, the air inlet comprises a first air inlet, the first fan is disposed above the first liquid cooling assembly, the first air inlet is disposed on a side surface of the first condenser, and the air outlet is disposed on a side surface of the first fan; and
the fan is configured to bring, through the air-cooled channel, airflow that enters the first air inlet to the air outlet, and the airflow in the air-cooled channel passes through the first condenser, to bring heat of the first condenser to the outside of the heat dissipation cavity.

15. The heat dissipation system according to claim 14, wherein the heat dissipation system further comprises a second liquid cooling assembly, a second power cavity, and a second power device, a second condenser of the second liquid cooling assembly is disposed on a side of the first condenser, the second power cavity is in contact with a second evaporator of the second liquid cooling assembly, and the second power device is disposed inside the second power cavity; and
the airflow in the air-cooled channel further passes through the second condenser, to bring heat of the second condenser to the outside of the heat dissipation cavity.

16. The heat dissipation system according to any one of claims 9 to 11 or claims 14 to 15, wherein the air cooling assembly further comprises a second air inlet, and the second air inlet is disposed at a bottom of the heat dissipation cavity, wherein
the first fan is further configured to bring, through the air-cooled channel, airflow that enters the second air inlet to the air outlet, and the airflow in the air-cooled channel further passes through any two of the first power cavity, the second power cavity, the first evaporator, and the second evaporator, to bring heat of any two of the first power cavity, the second power cavity, the first evaporator, and the second evaporator to the outside of the heat dissipation cavity.

17. The heat dissipation system according to claim 14 or 15, wherein the heat dissipation system further comprises a third liquid cooling assembly, a third power cavity, and a third power device, a third condenser of the third liquid cooling assembly is disposed below the first liquid cooling assembly, the third power cavity is in contact with a third evaporator of the third liquid cooling assembly, and the third power device is disposed inside the third power cavity; and
the airflow in the air-cooled channel further passes through the third condenser and the third evaporator, to bring heat of the third condenser and the third evaporator to the outside of the heat dissipation cavity; or
the airflow in the air-cooled channel further passes through the third condenser and the third power cavity, to bring heat of the third condenser and the third power cavity to the outside of the heat dissipation cavity.

18. The heat dissipation system according to claim 17, wherein the air cooling assembly further comprises a third air inlet, and the third air inlet is disposed on a side surface of the third condenser.

19. The heat dissipation system according to claim 2 or 3, wherein the air cooling assembly further comprises a first fan, the air inlet is disposed on a side surface of the first condenser, and the air outlet and the first fan are disposed at a bottom of the heat dissipation cavity and are located below the first liquid cooling assembly, and
the first fan is configured to bring, through the air-cooled channel, airflow that enters the air inlet to the air outlet, and the airflow in the air-cooled channel passes through the first condenser and the first evaporator, to bring heat of the first condenser and the first evaporator to the outside of the heat dissipation cavity; or
the first fan is configured to bring, through the air-cooled channel, airflow that enters the air inlet to the air outlet, and the airflow in the air-cooled channel passes through the first condenser and the first power cavity, to bring heat of the first condenser and the first cavity to the outside of the heat dissipation cavity.

20. The heat dissipation system according to claim 19, wherein the heat dissipation system further comprises a second liquid cooling assembly, a second power cavity, and a second power device, a second condenser of the second liquid cooling assembly is disposed on a side surface of the first condenser, the second power cavity is in contact with a second evaporator, and the second power device is disposed inside the second power cavity; and
a second fan is configured to bring, through the air-cooled channel, airflow that enters the air inlet to a second air outlet, and the airflow in the air-cooled channel further passes through the second condenser and the second evaporator, to bring heat of the second condenser and the second evaporator to the outside of the heat dissipation cavity; or
a second fan is configured to bring, through the air-cooled channel, airflow that enters the air inlet to a second air outlet, and the airflow in the air-cooled channel further passes through the second condenser and the second power cavity, to bring heat of the second condenser and the second cavity to the outside of the heat dissipation cavity.

21. A power supply system, wherein the power supply system comprises a power supply, the heat dissipation system according to any one of claims 1 to 20, and a load, wherein a power device in the heat dissipation system is connected to both the power supply and the load, the heat dissipation system is configured to dissipate heat for the power device, and the power device is configured to: convert initial electric energy provided by the power supply into target electric energy, and supply power to the load by using the target electric energy.

22. A charging pile, wherein the charging pile comprises a first electrical interface, a second electrical interface, and the heat dissipation system according to any one of claims 1 to 20, wherein
a power device in the heat dissipation system is connected to both a first power supply interface and a second power supply interface, the heat dissipation system is configured to dissipate heat for the power device, and the power device is configured to: convert initial electric energy input by the first electrical interface into target electric energy, and output the target electric energy through the second electrical interface.

23. The charging pile according to claim 22, wherein the power device is a DC/DC conversion module or an AC/DC conversion module.

24. The charging pile according to claim 22 or 23, wherein the first electrical interface is connected to a power supply, and the second electrical interface is connected to a load.

25. The charging pile according to claim 24, wherein the power supply is an alternating current power grid or a photovoltaic array, and the load is an electric vehicle or a robot.
